# EUROPÄISCHE PATENTANMELDUNG

(11) **EP 4 530 011 A2**
(43) Veröffentlichungstag der Anmeldung: **02.04.2025**
(21) Anmeldenummer: 25158329.0
(22) Anmeldetag: 19.02.2019
(51) Int. Cl.: B23K 103/00

(54) **VERFAHREN ZUM ERZEUGEN VON KURZEN UNTERKRITISCHEN RISSEN IN FESTKÖRPERN**

(30) Priorität: 20.02.2018 DE 102018001327
(62) Teilanmeldung aus: 19706949.5
(71) Anmelder: Siltectra GmbH, 01099 Dresden (DE)
(72) Erfinder: RICHTER, Jan, 01277 Dresden (DE); SWOBODA, Marko, 01097 Dresden (DE); ULLRICH, Albrecht, 01097 Dresden (DE); RIESKE, Ralf, 01099 Dresden (DE)
(74) Vertreter: Müller Hoffmann & Partner

(57) **Zusammenfassung**

Verfahren zum Erzeugen von Modifikationen (9) im Inneren eines Festkörpers (1). Das Verfahren umfasst das Einbringen von Laserstrahlung (14) eines Lasers (29) über eine erste Oberfläche (8) des Festkörpers (1) in das Innere des Festkörpers (1), wobei der Festkörper (1) eine Kristallstruktur ausbildet und wobei durch die Laserstrahlung (14) Modifikationen (9) an vorbestimmten Stellen auf einer Erzeugungsebene (4) im Inneren des Festkörpers (1) erzeugt werden, wobei die Modifikationen (9) näher zur ersten Oberfläche (8) beabstandet sind als zu einer zweiten Oberfläche, wobei die zweite Oberfläche parallel zur ersten Oberfläche (8) ausgebildet ist, wobei durch die Modifikationen (9) mehrere linienförmige Gestalten (103) erzeugt werden, wobei der Festkörper (1) im Bereich der jeweiligen Modifikation (9) unterkritisch einreißt, wobei die unterkritischen Risse orthogonal zur Längserstreckungsrichtung der jeweiligen linienförmigen Gestalt eine mittlere Risslänge von weniger als 150 µm aufweist, wobei Modifikationen (9), die zur selben linienförmigen Gestalt (103) gehören und nacheinander erzeugt werden in einem Abstand zueinander erzeugt werden, der durch die Funktion (d-x)/d<-0,31, definiert wird, wobei hierbei x>d gilt.

## Beschreibung

Der vorliegende Gegenstand bezieht sich gemäß der Ansprüche 1 und 3 jeweils auf Verfahren zum Erzeugen von Modifikationen im Inneren eines Festkörpers, gemäß Anspruch 14 auf ein Verfahren zum Abtrennen von mindestens einer Festkörperschicht von einem Festkörper und gemäß Anspruch 15 und 16 jeweils auf einen Festkörper mit einer vorteilhaften Topographie.

Die Druckschrift DE102017206178A1 offenbart ein Waferherstellungsverfahren mit einem Herstellen eines Wafers aus einem zylindrischen SiC-Einkristallingot, der eine zylindrische Umfangsfläche mit einer ersten Ausrichtungsebene und einer zweiten Ausrichtungsebene, die kürzer als die erste Ausrichtungsebene und senkrecht zu der ersten Ausrichtungsebene ist, aufweist und einer kreisförmigen oberen Fläche, wobei der zylindrische SiC-Einkristallingot eine c-Achse, die von einer vertikalen Achse senkrecht zu der kreisförmigen oberen Fläche in Richtung der zweiten Ausrichtungsebene geneigt ist, und einen Abweichungswinkel aufweist, der zwischen einer c-Ebene senkrecht zu der c-Achse und der oberen Fläche ausgebildet ist, wobei das Waferherstellungsverfahren umfasst: einen Erfassungsschritt für eine Bearbeitungszuführrichtung mit einem Bestätigen, ob eine Richtung, in der die c-Achse geneigt ist, und die zweite Ausrichtungsebene senkrecht zueinander sind oder nicht und einem Erfassen einer Bearbeitungszuführrichtung senkrecht zu der Richtung, in der die c-Achse geneigt ist;
einen Ausbildungsschritt für einen Bereich reduzierter Festigkeit mit einem Positionieren des Brennpunkts eines Laserstrahls von der kreisförmigen oberen Fläche aus in einer Tiefe in dem zylindrischen SiC-Einkristallingot, wobei die Tiefe der Dicke eines herzustellenden Wafers entspricht, und während eines relativen Bewegens des zylindrischen SiC-Einkristallingots und des Brennpunkts in der Bearbeitungszuführrichtung, die bei dem Erfassungsschritt für eine Bearbeitungszuführrichtung erfasst worden ist, Bestrahlen des zylindrischen SiC-Einkristallingots mit einem Laserstrahl, der eine Wellenlänge aufweist, die SiC überträgt, um dadurch einen geraden Bereich reduzierter Festigkeit auszubilden, der aus einer modifizierten Schicht parallel zu der kreisförmigen oberen Fläche und Rissen aufgebaut ist, die sich von der modifizierten Schicht in einer Tiefe entlang der c-Ebene erstrecken, die der Dicke des herzustellenden Wafers entspricht; einen Abziehebenenausbildungsschritt mit einem Ausbilden einer Abziehebene in dem zylindrischen SiC-Einkristallingot durch mehrmaliges Ausführen des Ausbildungsschritts für einen Bereich reduzierter Festigkeit mit vorbestimmten Abständen in einer Richtung senkrecht zu der Bearbeitungszuführrichtung; und nach dem Abziehebenenausbildungsschritt einen Waferherstellungsschritt mit einem Herstellen eines Wafers aus dem zylindrischen SiC-Einkristallingot durch Abziehen eines Abschnitts des zylindrischen SiC-Einkristallingots von der Abziehebene, die als Grenzfläche dient; wobei der Erfassungsschritt für eine Bearbeitungszuführrichtung einschließt: einen Abtastschritt mit einem Ausführen einer Abtastbestrahlung zum Positionieren des Brennpunkts eines Laserstrahls von der kreisförmigen oberen Fläche aus in einer vorbestimmten Tiefe in dem zylindrischen SiC-Einkristallingot und bei einem Bewegen des zylindrischen SiC-Einkristallingots und des Brennpunkts relativ zueinander, Bestrahlen des zylindrischen SiC-Einkristallingots mit einem Laserstrahl, der eine Wellenlänge aufweist, die SiC überträgt, entlang einer Richtung parallel zu der zweiten Ausrichtungsebene und einer Vielzahl von Richtungen, die im Uhrzeigersinn und gegen den Uhrzeigersinn durch jeweilige vorbestimmte Winkel von der zweiten Ausrichtungsebene aus geneigt sind, um dadurch in dem zylindrischen SiC-Einkristallingot eine Vielzahl abgetasteter gerader Bereiche reduzierter Festigkeit auszubilden, wobei jeder der abgetasteten geraden Bereiche reduzierter Festigkeit aus einer modifizierten Schicht parallel zu der kreisförmigen oberen Fläche und Rissen aufgebaut ist, die sich von der modifizierten Schicht entlang der c-Ebene erstrecken, und einen Bestimmungsschritt mit einem Aufnehmen jeweiliger Bilder der abgetasteten geraden Bereiche reduzierter Festigkeit mit einem Abbildungsmittel, Messen der Knotenanzahl, die pro Längeneinheit bei jedem der abgetasteten geraden Bereiche reduzierter Festigkeit in einem ihrer Bilder vorliegt, und Bestimmen einer Richtung, in welcher sich der abgetastete gerade Bereich reduzierter Festigkeit, wo die gemessene Knotenanzahl null ist, als Bearbeitungszuführrichtung erstreckt.

Die Druckschrift DE102016208958A1 offenbart ein Wafer-Herstellungsverfahren zum Herstellen eines hexagonalen Einkristall-Wafers aus einem hexagonalen Einkristall-Ingot. Das Wafer-Herstellungsverfahren schließt einen Trennstartpunktausbildungsschritt mit einem Einstellen des Brennpunkts eines Laserstrahls ein, der eine Transmissionswellenlänge für den Ingot aufweist, auf eine von der oberen Fläche des Ingots aus vorbestimmte Tiefe im Inneren des Ingots, wobei die Tiefe der Dicke des herzustellenden Wafers entspricht, und als Nächstes einem Aufbringen des Laserstrahls auf die obere Fläche des Ingots bei einem relativen Bewegen des Brennpunkts und des Ingots, um damit eine modifizierte Schicht parallel zu der oberen Fläche des Ingots und Risse auszubilden, die sich von der modifizierten Schicht erstrecken, um so einen Trennstartpunkt auszubilden. Der Laserstrahl wird aufgebracht, um die modifizierte Schicht in einem Zustand auszubilden, in dem die Beziehung -0,3 ≤ (d - x)/d ≤ 0,5 eingehalten wird, wobei d der Durchmesser eines Brennpunkts des Laserstrahls ist und x der Abstand zwischen nebeneinanderliegenden Brennpunkten des Laserstrahls ist. Dabei gilt: d = 1.22 * lambda / Na, wobei lambda die Wellenlänge des Laser repräsentiert und Na die numerische Apertur der Abbildung repräsentiert.

Die zuvor genannten Verfahren sind nachteilig, da Fokusse so nah nebeneinander gewählt werden, dass der nachfolgende Fokus in einem phasenumgewandelten Anteil liegt. Dies bewirkt jedoch, dass die Absorption sehr stark zunimmt. Treten nun Materialparameterschwankungen, wie z.B. Defekte, Einschlüsse oder Dotierungen auf, so kann die Absorption nochmals deutlich erhöht werden, wodurch der Prozess der Materialumwandlung unkontrollierbar wird bzw. unkontrolliert große Anteile im Inneren des Festkörpers umgewandelt werden. Es tritt somit eine positive Rückkopplung auf. Durch diese positive Rückkopplung werden dann größere Mengen Material umgewandelt, wodurch größere Druckspannungen im Inneren des Festkörpers entstehen. Diese größeren Druckspannungen bewirken, dass die Rissausbreitung stärker erfolgt. Da bei Siliziumkarbid die Rissausbreitung in der Regel in Kristallgitterebenenrichtung erfolgt und das Kristallgitter bei Siliziumkarbid Ingots oder Boules in der Regel in einem Winkel von 4° geneigt ist. Bewirken weit laufende Risse eine Beschädigung der umliegenden Festkörperstruktur. Diese beschädigten Anteile müssen dann mittels eines Schleifverfahrens entfernt werden. Daher bedeutet die Reduzierung von Beschädigungen unmittelbar eine Erhöhung des Outputs und eine Reduzierung des Nachbearbeitungsaufwands.

### Aufgabe

Es ist somit die Aufgabe eine Lösung bereitzustellen, die zu geringeren Beschädigungen des Festkörpermaterials führt.

### Beschreibung

Die zuvor genannte Aufgabe wird z.B. durch ein Verfahren zum Erzeugen von Modifikationen im Inneren eines Festkörpers nach Anspruch 1 gelöst. Dieses Verfahren weist dabei bevorzugt mindestens den Schritt auf, dass Laserstrahlung eines Lasers über eine erste Oberfläche des Festkörpers in das Innere des Festkörpers eingebracht wird, wobei der Festkörper eine Kristallstruktur ausbildet und wobei durch die Laserstrahlung Modifikationen an vorbestimmten Stellen auf einer Erzeugungsebene im Inneren des Festkörpers erzeugt werden. Die Modifikationen sind dabei bevorzugt näher zur ersten Oberfläche beabstandet als zu einer zweiten Oberfläche, wobei die zweite Oberfläche bevorzugt parallel zur ersten Oberfläche ausgebildet ist. Hierbei dringt die Laserstrahlung zur Erzeugung der Modifikationen bevorzugt über die erste Oberfläche oder die zweite Oberfläche in den Festkörper ein.

Es ist jedoch alternativ auch möglich, dass die Modifikationen näher zur zweiten Oberfläche beabstandet sind als zur ersten Oberfläche. Hierbei dringt die Laserstrahlung zur Erzeugung der Modifikationen bevorzugt über die erste Oberfläche oder die zweiter Oberfläche in den Festkörper ein.

Somit können die Laserstrahlen bevorzugt über die erste Oberfläche in den Festkörper eindringen und die Modifikationen werden dann weiter von der ersten Oberfläche als von der zweiten Oberfläche beabstandet erzeugt. Die Erzeugungsebene liegt dann näher zur zweiten Oberfläche beabstandet als zur ersten Oberfläche.

Durch die Modifikationen werden bevorzugt mehrere linienförmige Gestalten, insbesondere Schreiblinien, erzeugt. Die linienförmigen Gestalten erstrecken sich bevorzugt mehrheitlich gebogen oder geradlinig. Der Festkörper reißt im Bereich der jeweiligen Modifikation bevorzugt unterkritisch ein. Die unterkritischen Risse weisen bevorzugt orthogonal zur Längserstreckungsrichtung der jeweiligen linienförmigen Gestalt eine mittlere Risslänge von weniger als 150 µm, insbesondere von weniger als 120 µm oder weniger als 110 µm oder weniger als 90 µm oder weniger als 75 µm oder weniger als 60 µm, auf. Bevorzugt sind die unterkritischen Risse kürzer als der doppelte Linienabstand (=Hatch).

Die Modifikationen, die zur selben linienförmigen Gestalt gehören und nacheinander erzeugt werden, werden bevorzugt in einem Abstand zueinander erzeugt, der durch die Funktion (d-x)/d<-0,31, insbesondere <-0,4, definiert wird, wobei hierbei bevorzugt x>d gilt.

Auf Höhe der Erzeugungsebene oder bevorzugt parallel dazu können sich die unterkritischen Risse ausbreiten und dadurch eine Ablöseebene ausbilden. Die Ablöseebene kann daher näher als die Erzeugungsebene zur ersten Oberfläche beabstandet sein oder die Ablöseebene kann weiter als die Erzeugungsebene zur ersten Oberfläche beabstandet sein.

Als "im Bereich" der Modifikation kann hierbei derart verstanden werden, dass der Festkörper im modifizierten bzw. materialumgewandelten Anteil und im sich dazu benachbarenden Festkörperanteil einreißt. Es ist jedoch ebenfalls möglich, dass der modifizierte Bereich nicht einreißt, sondern der Riss in Festkörperlängsrichtung oberhalb oder unterhalb der Modifikation/en einreißt. Reißt der Festkörper oberhalb oder unterhalb der Modifikation/en ein, dann beträgt der Abstand des Risses (insbesondere des unterkritischen Risses) zur Erzeugungsebene bevorzugt weniger als 20µm, insbesondere weniger als 15µm oder weniger als 10µm oder weniger als 5µm oder weniger als 4µm oder weniger als 3µm oder weniger als 2µm oder weniger als 1 µm.

Diese Lösung ist vorteilhaft, da durch die angegebene Bedingung (d-x)/d<-0,31 definiert wird, dass die Fokuspunkte der nacheinander erzeugten Modifikationen derselben linienförmigen Gestalt soweit voneinander beabstandet sind, dass die zuvor erzeugte Materialumwandung bei der danach erfolgenden Materialumwandung keine oder nur geringe Effekte, insbesondere keine oder nur gering erhöhte Absorption, bewirkt. Dies ist vorteilhaft, da die Modifikationen dadurch sehr präzise erzeugt werden können, wodurch die Neigung von unterkritischen Rissen sich stärker auszubreiten besser kontrolliert werden kann.

Weitere bevorzugte Ausführungsformen sind Gegenstand der Unteransprüche und der nachfolgenden Beschreibungsteile.

Gemäß einer weiteren bevorzugten Ausführungsform ist die Laserstrahlung definiert polarisiert. Die Polarisationsrichtung der Laserstrahlung ist dabei bevorzugt in einem definierten Winkel, insbesondere festem Winkel von 0° oder 90°, oder definierten Winkelbereich, insbesondere -20° bis 20° oder -10° bis 10° oder -5° bis 5° oder -1° bis 1° oder 70° bis 110° oder 80° bis 100° oder 85° bis 95° oder 89° bis 91 °, gegenüber der Kristallachse des Festkörpers orientiert. Alternativ kann die Längserstreckungsrichtung der mittels der Laserstrahlen im Inneren des Festkörpers erzeugten Modifikationen in einem definierten Winkel, insbesondere festem Winkel von 0° oder 90°, oder definierten Winkelbereich, insbesondere -20° bis 20° oder -10° bis 10° oder -5° bis 5° oder -1° bis 1° oder 70° bis 110° oder 80° bis 100° oder 85° bis 95° oder 89° bis 91°, gegenüber einer sich an der Schnittstelle zwischen der Erzeugungsebene und der Kristallgitterebene ergebenden Schnittlinie, insbesondere virtuellen Schnittebene, ausgerichtet sein.

Bei einer Polarisation des Lasers parallel zum Hauptflat wurde bei Laserbearbeitung in die C-Seite des SiC-Substrats festgestellt, dass es einer um ca. 50% höhere Laserenergie bedarf, um vergleichbare Schadmuster auszubilden, gegenüber einer Laserpolarisation senkrecht zum Hauptflat in dieser Konfiguration. Wird zirkular polarisiertes Licht verwendet, so wird bei einem Polarisator entgegen der Durchlasspolarisation eine um 1/3 verminderte transmittierte Laserleistung gemessen. Dies bedeutet, dass für zirkular polarisiertes Licht die genutzte Laserenergie gegenüber der linearen Idealpolarisation wahrscheinlich um einen Betrag von bis zu 50% erhöht werden muss. Insbesondere durch die Nichtlinearität des Prozesses und der Wirkungsquerschnitte für Multiphotoneneffekte in SiC für zirkular polarisiertes Licht kann dieser Unterschied jedoch auch geringer sein. Ein Wert zwischen den Schwellenergien für ideale und dazu um 90° gedrehter Laserpolarisation ist dementsprechend auch möglich, da im Zuge der rotierenden Laserpolarisation beide Polarisationen transient überstrichen werden. Multiphotoneneffekte haben jedoch meist bessere Wirkungsquerschnitte für linear polarisiertes Licht, sodass für perfekt zirkular polarisiertes Licht noch größere Energien aufgewandt werden müssen.

Die zuvor genannte Aufgabe kann ebenfalls durch ein Verfahren zum Erzeugen von Modifikationen im Inneren eines Festkörpers nach Anspruch 3 gelöst. Dieses Verfahren weist dabei bevorzugt mindestens den Schritt auf, dass Laserstrahlung eines Lasers über eine erste Oberfläche des Festkörpers in das Innere des Festkörpers eingebracht wird, wobei der Festkörper eine Kristallstruktur ausbildet und wobei durch die Laserstrahlung Modifikationen an vorbestimmten Stellen auf einer Erzeugungsebene im Inneren des Festkörpers erzeugt werden. Die Modifikationen sind dabei bevorzugt näher zur ersten Oberfläche beabstandet als zu einer zweiten Oberfläche, wobei die zweite Oberfläche bevorzugt parallel zur ersten Oberfläche ausgebildet ist. Hierbei dringt die Laserstrahlung zur Erzeugung der Modifikationen bevorzugt über die erste Oberfläche oder die zweite Oberfläche in den Festkörper ein.

Es ist jedoch alternativ auch möglich, dass die Modifikationen näher zur zweiten Oberfläche beabstandet sind als zur ersten Oberfläche. Hierbei dringt die Laserstrahlung zur Erzeugung der Modifikationen bevorzugt über die erste Oberfläche oder die zweite Oberfläche in den Festkörper ein.

Somit können die Laserstrahlen bevorzugt über die erste Oberfläche in den Festkörper eindringen und die Modifikationen werden dann weiter von der ersten Oberfläche als von der zweiten Oberfläche beabstandet erzeugt. Die Erzeugungsebene liegt dann näher zur zweiten Oberfläche beabstandet als zur ersten Oberfläche.

Durch die Modifikationen werden bevorzugt mehrere linienförmige Gestalten, insbesondere Schreiblinien, erzeugt. Die linienförmigen Gestalten erstrecken sich bevorzugt mehrheitlich gebogen oder geradlinig. Der Festkörper reißt im Bereich der jeweiligen Modifikation bevorzugt unterkritisch ein. Die unterkritischen Risse weisen bevorzugt orthogonal zur Längserstreckungsrichtung der jeweiligen linienförmigen Gestalt eine mittlere Risslänge von weniger als 150 µm, insbesondere von weniger als 120 µm oder weniger als 110 µm oder weniger als 90 µm oder weniger als 75 µm oder weniger als 60 µm, auf. Bevorzugt sind die unterkritischen Risse kürzer als der doppelte Hatch.

Die Laserstrahlung ist bevorzugt definiert polarisiert bzw. wird definiert polarisiert. Die Polarisationsrichtung der Laserstrahlung ist bevorzugt in einem definierten Winkel, insbesondere festem Winkel von 0° oder 90°, oder definierten Winkelbereich, insbesondere - 20° bis 20° oder -10° bis 10° oder -5° bis 5° oder -1° bis 1° oder 70° bis 110° oder 80° bis 100° oder 85° bis 95° oder 89° bis 91°, gegenüber der Kristallachse des Festkörpers orientiert. Alternativ kann die Längserstreckungsrichtung der mittels der Laserstrahlen im Inneren des Festkörpers erzeugten Modifikationen in einem definierten Winkel, insbesondere festem Winkel von 0° oder 90°, oder definierten Winkelbereich, insbesondere -20° bis 20° oder -10° bis 10° oder -5° bis 5° oder -1 ° bis 1° oder 70° bis 110° oder 80° bis 100° oder 85° bis 95° oder 89° bis 91°, gegenüber einer sich an der Schnittstelle zwischen der Erzeugungsebene und der Kristallgitterebene ergebenden Schnittlinie ausgerichtet sein.

Die mittlere Risslänge wird hierbei bevorzugt in einer Ebene bestimmt, d.h. die Rissausbreitung in orthogonaler Richtung zur Längserstreckungsrichtung der linienförmigen Gestalt wird in derselben Ebene einerseits und andererseits der linienförmigen Gestalt erfasst und bevorzugt modifikationsaufgelöst ausgewertet bzw. bestimmt.

Der Festkörper kann hierbei Siliziumkarbid aufweisen oder aus Siliziumkarbid, insbesondere aus dotiertem Siliziumkarbid, bestehen.

Gemäß einer weiteren bevorzugten Ausführungsform werden Modifikationen, die zur selben linienförmigen Gestalt gehören und nacheinander erzeugt werden, in einem Abstand zueinander erzeugt, der durch die Funktion (d-x)/d<0, insbesondere <-0,3 oder <-0,31 oder <-0,4 oder <-0,45 oder <-0,5 oder <-0,55 oder <-0,6 oder <-0,65 oder <-0,7 oder <-0,75, definiert wird, wobei hierbei bevorzugt x>d gilt. Die Aussage <-0,31 bedeutet hierbei kleiner als -0,31, dies sind hierbei betragsmäßig größere Zahlen, wie z.B. -0,5. -0,1 hingegen ist betragsmäßig kleiner als der Betrag von -0,31 somit wäre -0,1 nicht umfasst.

Gemäß einer weiteren bevorzugten Ausführungsform sind die nacheinander erzeugten Modifikationen einer linienförmigen Gestalt durch unmodifiziertes Festkörpermaterial voneinander getrennt. D.h., dass der durch die Lasermodifikation bewirkte Phasenwechsel zwischen einzelnen Modifikationen bevorzugt nicht erfolgt. Die einzelnen Modifikationen einer linearen Gestalt sind somit bevorzugt räumlich soweit voneinander separiert, dass eine zuvor erfolgte Materialumwandung keine Auswirkung auf die Absorption bei einer unmittelbar danach für dieselbe lineare Gestalt erzeugten Modifikation hat. Hieraus resultiert somit ein Punktmuster bzw. die linienförmige Gestalt wird durch ein Punktmuster gebildet.

Der Abstand zwischen jeweils zwei unmittelbar nebeneinanderliegenden linienförmigen Gestalten beträgt gemäß einer weiteren bevorzugten Ausführungsform weniger als 50µm, insbesondere weniger als 40µm oder weniger als 30µm oder weniger als 25µm oder weniger als 20µm oder weniger als 15µm oder weniger als 10µm. Diese Lösung ist vorteilhaft, da eine Rissfront geschaffen wird, welche der freigelegten Oberfläche des verbleibenden Restfestkörpers und der freigelegten Oberfläche der abgetrennten Festkörperschicht eine charakteristische Gestalt aufprägt. Diese charakteristische Gestalt bildet auf Seiten der Festkörperschicht und/oder auf Seiten des Restfestkörpers bevorzugt zick-zack-förmige Erhebungen und/oder Täler aus. Dies gilt für alle Festkörper, deren Kristallebenen und/oder Gleitebenen, d.h. bevorzugte Rissebenen, gegenüber der ersten Oberfläche, durch die die Laserstrahlung in den Festkörper eingebracht wird, geneigt sind.

Die in dem Festkörper erzeugten Modifikationen werden gemäß einer weiteren bevorzugten Ausführungsform zu einem ersten Teil während einer ersten Relativbewegung des Festkörpers gegenüber einer Optik des Lasers erzeugt und zu einem zweiten Teil während einer zweiten Relativbewegung des Festkörpers gegenüber der Optik des Lasers erzeugt werden. Die erste Relativbewegung ist dabei bevorzugt eine geradlinige Bewegung in einer ersten Richtung und die zweite Relativbewegung ist dabei bevorzugt eine geradlinige Bewegung in einer zweiten Richtung, wobei die Überfahrwege bevorzugt parallel zueinander sind. Bevorzugt bildet der gesamte Verfahrweg eine Mäanderform aus oder eine durch einen X-Y-Tisch bewirkte Verfahrbewegung.

Mindestens die Einstellung eines Laserparameters, insbesondere die Polarisierung, gemäß einer weiteren bevorzugten Ausführungsform während der ersten Relativbewegung von der Einstellung während der zweiten Relativbewegung abweicht, wobei die erste Relativbewegung einer linearen Bewegung in einer ersten Richtung entspricht und die zweite Relativbewegung einer linearen Bewegung in einer zweiten Richtung entspricht, wobei die erste Richtung und die zweite Richtung parallel versetzt zueinander orientiert sind.

Die Laserstrahlung ist gemäß einer weiteren bevorzugten Ausführungsform linear polarisiert oder elliptisch polarisiert oder zirkular polarisiert. Diese Ausführungsform ist vorteilhaft, da durch eine definierte Polarisation der Laserstrahlung Modifikationen erzeugt werden können, die eine sehr kurze, insbesondere kürzer als 100 µm, Rissausbreitung der unterkritischen Risse ermöglicht.

Gemäß einer weiteren bevorzugten Ausführungsform weist das Verfahren bevorzugt ebenfalls den Schritt des Veränderns einer Strahleigenschaften der Laserstrahlen vor dem Eindringen in den Festkörper auf, wobei die Strahleigenschaft die Intensitätsverteilung im Fokus ist, wobei die Veränderung oder Anpassung der Strahleigenschaft von mindestens oder genau einem Spatial Light Modulator und/oder von mindestens oder genau einem DOE bewirkt wird, wobei der Spatial Light Modulator und/oder das DOE im Strahlengang der Laserstrahlung zwischen dem Festkörper und der Strahlungsquelle angeordnet ist.

Im Weg der Laserstrahlung ist gemäß einer weiteren bevorzugten Ausführungsform vor dem Eindringen der Laserstrahlung in das Spendersubstrat bzw. in den Festkörper ein diffraktives optisches Element (DOE) angeordnet. Die Laserstrahlung wird durch das DOE auf mehrere Lichtpfade zum Erzeugen mehrerer Fokusse aufgeteilt. Das DOE bewirkt bevorzugt über eine Länge von 200µm eine Bildfeldwölbung, die kleiner oder gleich 50µm, insbesondere kleiner oder gleich 30µm oder kleiner oder gleich 10µm oder kleiner oder gleich 5 µm oder kleiner oder gleich 3µm, ist, wobei durch das DOE zumindest 2 und bevorzugt mindestens oder genau 3 oder mindestens oder genau 4 oder mindestens oder genau 5 oder mindestens oder genau oder bis zu 10 oder mindestens oder genau oder bis zu 20 oder mindestens oder genau oder bis zu 50 oder bis zu 100 Fokusse zur Veränderung der Materialeigenschaften des Spendersubstrats oder Festkörpers zeitgleich erzeugt werden. Diese Ausführungsform ist vorteilhaft, da eine signifikante Prozessbeschleunigung erzielt werden kann.

Es wurde somit erkannt, dass hohe Leistungen mit diffraktiven optischen Elementen (DOEs) auf mehrere Foki in der Brennebene aufgeteilt werden. DOEs zeigen Interferenzerscheinungen schon vor der Brennebene, es wurde erkannt, dass Interferenzen an der Oberfläche, vor der Brennebene lokale Intensitätsmaxima erzeugen können, die zur Schädigung der Oberfläche führen können und zu einer verringerten Transmissivität für Laserstrahlung zur Bearbeitung in der Tiefe führen können. Weiterhin wurde erkannt, dass manche Materialien (Bsp: SiC) lokale Brechindex- und andere Materialeigenschaftsunterschiede (z.B. Absorption, Transmission, Streuung), z.B. durch die Materialdotierung (häufiges Auftreten: Dotierfleck) haben. Ferner wurde erkannt, dass abhängig von der Oberflächenrauhigkeit des Materials an der Lasereinkoppeloberfläche die Wellenfront des Lasers in der Tiefe des Materials signifikant beeinträchtigt werden kann, sodass der Fokus reduzierte Intensität aufweist (geringere Multiphotonenübergangswahrscheinlichkeit), was wieder höhere Intensitäten mit oben genannten Problemen nach sich ziehen würde.

Eine Einstrahlung der Laserstrahlen auf bzw. in den Festkörper bzw. das Spendersubstrat unter dem Brewster-Winkel ist kompliziert bzw. kann anspruchsvoll sein, da die unterschiedlichen Strahlanteile unterschiedlich lange Wege im hochbrechenderen Medium zurücklegen. Der Fokus muss dementsprechend durch höhere Energie angepasst werden und/oder durch Strahlformung. Die Strahlformung erfolgt hierbei bevorzugt z.B. über ein oder mehrere diffraktive optische Element/e (DOE), was diesen Unterschied abhängig über das Laserstrahlprofil ausgleicht. Der Brewster-Winkel ist relativ groß, was bei hoher numerischer Apertur Anforderungen an die Optik und deren Maße sowie Arbeitsabstand stellt. Dennoch ist diese Lösung vorteilhaft, da reduzierte Reflexionen an der Oberfläche auch zu reduzierter Oberflächenschädigung beitragen, da die Lichtintensität besser ins Material hineinkoppelt. Im Sinne des vorliegenden Gegenstands können Laserstrahlen auch in allen anderen in dieser Schrift offenbarten Ausführungsformen im Brewster-Winkel oder überwiegend oder mehrheitlich im Brewster-Winkel eingestrahlt werden. Zur Brewster-Winkel-Einkopplung wird hiermit auf das Dokument "Optical Properties of Spin-Coated TiO2 Antireflection Films on Textured Single-Crystalline Silicon Substrates" (Hindawi Publishing Corporation International Journal of Photoenergy, Volume 2015, Article ID 147836, 8 pages, http://dx.doi.org/10.1155/2015/147836) verwiesen. Dieses Dokument wird durch Bezugnahme vollumfänglich zum Gegenstand der vorliegenden Patentanmeldung gemacht. Das zuvor genannte und einbezogene Dokument offenbart insbesondere Berechnungen zum optimalen Einstrahlwinkel für verschiedene Materialien und damit Brechindizes. Die Energie des Lasers bzw. der Laserbeaufschlagungseinrichtung wird nicht so sehr in Abhängigkeit vom Material, sondern eher von der möglichen Transmission unter einem bestimmten Winkel angepasst. Wenn also die optimale Transmission z.B. 93% beträgt, so müssen diese Verluste gegenüber Versuchen mit senkrechter Einstrahlung und Verlusten von z.B. dann 17% berücksichtigt werden und die Laserleistung dementsprechend angepasst werden.

Ein Beispiel: 83% Transmission senkrecht gegenüber 93% unter Winkel, bedeutet, dass zum Erzielen der gleichen Energie in der Tiefe, nur noch 89% der bei senkrechter Einstrahlung verwendeten Laserleistung benötigt werden (0.83/0.93=0.89). Im Sinne des vorliegenden Gegenstands dient der Teil der schrägen Einstrahlung also bevorzugt dazu weniger Licht durch Oberflächenreflexion zu verlieren und mehr in die Tiefe zu bringen. Ein mögliches nachgelagertes Problem, das dadurch in bestimmten Konstellationen auftreten kann, ist, dass der Fokus in der Tiefe ein "schiefes" Profil erhalten kann und damit die erreichten Intensitäten - die Schlüsselgröße für Multiphotonenbearbeitung - wieder geringer sind, eventuell also sogar geringer als bei senkrechter Einstrahlung, wo alle Strahlanteile denselben optischen Weg im Material durchlaufen. Dies kann dann bevorzugt durch ein diffraktives optisches Element oder durch mehrere diffraktive Elemente oder einen durchlaufenden Keil oder mehrere durchlaufende Keile - und/oder andere optische Elemente - im Strahlengang geschehen, die diese zusätzlichen Wege und/oder den Einfluss auf die einzelnen Strahlen - insbesondere unterschiedliche sphärische Aberrationen über das Strahlprofil hin - kompensieren. Diese DOEs kann man numerisch mit geeigneten Softwarelösungen (z.B. Virtuallab von Lighttrans, Jena) berechnen und dann fertigen bzw. bereitstellen.

Die Modifikationen werden gemäß einer weiteren bevorzugten Ausführungsform bevorzugt mittels einer Mehrphotonenanregung, insbesondere einer Zweiphotonenanregung, erzeugt.

Das Verfahren kann einen oder mehrere oder alle der nachfolgenden Schritte umfassen:
Bewegen des Festkörpers relativ zu einer Laserbeaufschlagungseinrichtung, nacheinander Erzeugen von einer Vielzahl an Laserstrahlen mittels der Laserbeaufschlagungseinrichtung zum Erzeugen von jeweils mindestens einer Modifikation, wobei die Laserbeaufschlagungseinrichtung zur definierten Fokussierung der Laserstrahlen und/oder zur Anpassung der Laserenergie, insbesondere kontinuierlich, in Abhängigkeit von mindestens einem Parameter, insbesondere von einer Vielzahl an Parametern eingestellt wird.

Der LASER-Strahl dringt bevorzugt über eine ebene Oberfläche des Spendersubstrats in das Spendersubstrat ein. Bevorzugt ist der LASER-Strahl derart gegenüber der, insbesondere ebenen, Oberfläche des Spendersubstrats bzw. Festkörpers geneigt, dass er in einem Winkel von ungleich 0° oder 180° gegenüber der Längsachse des Spendersubstrates in das Spendersubstrat eindringt. Bevorzugt wird der LASER-Strahl zum Erzeugen der Modifikation im Spendersubstrat fokussiert.

Der Festkörper weist bevorzugt Kristallgitterebenen auf, die gegenüber einer ebenen Hauptoberfläche geneigt sind, wobei die Hauptoberfläche des Festkörpers in Längsrichtung des Festkörpers einerseits begrenzt, wobei sich eine Kritallgitterebenennormale gegenüber einer Hauptoberflächennormalen in eine erste Richtung neigt, wobei die Modifikationen Veränderungen der Materialeigenschaft des Spendersubstrats sind. Die Veränderung der Materialeigenschaft bildet durch Verändern des Eindringortes der Laserstrahlung in dem Festkörper zumindest abschnittsweise eine linienförmige Gestalt aus, wobei die linienförmige Gestalt als Punktlinie, Strichlinie oder durchgehende Linie ausgebildet sein kann. Bevorzugt weist die linienförmige Gestalt oder mehrere linienförmige Gestalten oder alle oder die Mehrzahl der linienförmigen Gestalten eine Länge von mehr als 1mm oder von mehr als 5mm oder von mehr als 10mm oder von mehr als 20mm oder von mehr als 30mm auf oder eine von bis zu 1mm oder von bis zu 5mm oder von bis zu 10mm oder von bis zu 20mm oder von bis zu 30mm oder von bis zu 50mm oder von bis zu 100mm auf. Die Veränderungen der Materialeigenschaft werden bevorzugt auf einer Erzeugungsebene, insbesondere auf mindestens einer Erzeugungsebene oder auf genau einer Erzeugungsebene, erzeugt. Bevorzugt sind die Kristallgitterebenen des Festkörpers gegenüber der Erzeugungsebene geneigt ausgerichtet. Die linienförmigen Gestalten sind bevorzugt gegenüber einer sich an der Schnittstelle zwischen der Erzeugungsebene und der Kristallgitterebene ergebenden Schnittlinie geneigt, insbesondere in einem Winkel, insbesondere zwischen 2° und 30°, insbesondere in einem Winkel zwischen 3° und 9° oder in einem Winkel von mindestens oder genau oder bis zu 3° oder in einem Winkel von mindestens oder genau oder bis zu 4° oder in einem Winkel von mindestens oder genau oder bis zu 5° oder in einem Winkel von mindestens oder genau oder bis zu 6° oder in einem Winkel von mindestens oder genau oder bis zu 7° oder in einem Winkel von mindestens oder genau oder bis zu 8° oder in einem Winkel von genau oder bis zu 15°, ausgerichtet.

Die Laserstrahlung wird gemäß einer weiteren bevorzugten Ausführungsform mit Pulslängen von weniger als 5ns oder weniger als 2ns, insbesondere von weniger als 1 ns oder von weniger als 700ps oder von weniger als 500ps oder von weniger als 400ps oder von weniger als 300ps oder von weniger als 200ps oder von weniger als 150ps oder von weniger als 100ps oder von weniger als 50ps oder von weniger als 10ps, erzeugt.

Bevorzugt werden Veränderungen der Materialeigenschaft bzw. Modifikationen jeweils mit Laserpulsen erzeugt, die kurzer sind als 5ns, insbesondere kürzer als 2ns oder 1ns sind. Besonders bevorzugt liegt die zeitliche Dauer der einzelnen Laserpulse zwischen 50ps und 4000ps oder zwischen 50ps und 2000ps oder zwischen 50ps und 1000ps, insbesondere zwischen 50ps und 900ps oder zwischen 50ps und 700ps oder zwischen 50ps und 500ps oder zwischen 50ps und 300ps oder zwischen 300ps und 900ps oder zwischen 500ps und 900ps oder zwischen 700ps und 900ps oder zwischen 300ps und 500ps oder zwischen 500ps und 700ps oder zwischen 300ps und 700ps oder kürzer als 900ps oder kürzer als 700ps oder kürzer als 500ps oder kürzer als 300ps oder kürzer als 100ps oder kürzer als 50ps.

Die Laserstrahlung wird gemäß einer weiteren bevorzugten Ausführungsform mit Pulsenergien erzeugt, wobei die Pulsenergien zwischen 100 nJ und 1 mJ oder 500 nJ und 100 µJ oder 1 µJ und 50 µJ liegen. Bevorzugt liegt die Pulsenergie pro Einzelschuss bei 0,1-50 µJ nach dem Objektiv bzw. nach dem letzten optischen Aufbereitungsmittel und vor dem Eindringen der Laserstrahlung in den Festkörper. Sollten z.B. mittels eines DOEs mehrere Fokusse erzeugt werden, so weist die jedem einzelnen Fokus zugeordnete Laserstrahlung nach dem Objektiv bzw. nach dem letzten optischen Aufbereitungsmittel und vor dem Eindringen der Laserstrahlung in den Festkörper eine Pulsenergie von 0,1-50 µJ auf.

Gemäß einer weiteren bevorzugten Ausführungsform wird zur definierten Temperierung bzw. zum Erzeugen der Modifikation bzw. zum Verändern, insbesondere zum lokalen Verändern, einer Materialeigenschaft des Spendersubstarts die LASER-Strahlung mit einer Pulsdichte zwischen 0,1nJ/µm2 und 10000 nJ/µm2 bevorzugt zwischen 1 nJ/µm2 und 1000 nJ/µm2 und besonders bevorzugt zwischen 3nJ/µm2 und 200 nJ/µm2 in den Festkörper eingebracht.

Gemäß einer weiteren bevorzugten Ausführungsform werden Auslösemodifikation zum Auslösen von unterkritischen Rissen erzeugt, wobei zumindest ein Prozessparameter zum Erzeugen der Auslösemodifikationen von zumindest einem Prozessparameter zum Erzeugten der Basis-Modifikationen verschieden ist, bevorzugt sind mehrere Prozessparameter voneinander verschieden. Zusätzlich oder alternativ können die Auslösemodifikationen in einer Richtung erzeugt werden, die zur Verlaufsrichtung der Linie, entlang der die Basis-Modifikationen erzeugt werden, geneigt oder beabstandet ist.

Die unterkritischen Risse, insbesondere erzeugt durch Auslösemodifikationen und/oder durch den Ablösebereich bzw. die Ablöseebene definierende Modifikationen bzw. durch eine linienförmige Gestalt ausbildende Modifikationen, breiten sich bevorzugt weniger als 5mm, insbesondere weniger als 3mm oder weniger als 1mm oder weniger als 0,5mm oder weniger als 0,25mm oder weniger als 0,1mm, aus. Eine geneigte Ausrichtung kann hierbei z.B. einem Winkel zwischen 0° und 90° entsprechen, bevorzugt einem Winkel zwischen 85° und 90° und besonders bevorzugt einen Winkel von 90°.

Es handelt sich um einen Schwellprozess, der ausgelöst wird, wenn eine kritische Intensität (also Leistung/Fläche) überschritten wird. Das heißt, kurze Pulse brauchen weniger Energie/Puls, höhere numerische Apertur konzentriert die Energie auf einen kleineren Punkt, braucht also auch niedrigere Energie um die Schwellintensität zu erreichen.

Das Verfahren umfasst bevorzugt ebenfalls einen oder mehrere der nachfolgend genannten Schritte: Bereitstellen des Spendersubstrats bzw. des Bereitstellens eines Spendersubstrats (bzw. Festkörpers) das Kristallgitterebenen aufweist, die gegenüber einer ebenen Hauptoberfläche geneigt sind. Die Hauptoberfläche das Spendersubstrat ist dabei bevorzugt in Längsrichtung des Spendersubstarts einerseits begrenzt, wobei sich eine Kritallgitterebenennormale gegenüber einer Hauptoberflächennormalen in eine erste Richtung neigt. Bereitstellen von mindestens einem Laser. Einbringen von Laserstrahlung des Lasers in das Innere des Festkörpers bevorzugt über die Hauptoberfläche zum Verändern der Materialeigenschaften des Festkörpers im Bereich von mindestens einem Laserfokus. Der Laserfokus wird bevorzugt durch von dem Laser emittierten Laserstrahlen des Lasers gebildet. Die Veränderung der Materialeigenschaft bildet durch Verändern des Eindringortes der Laserstrahlung in das Spendersubstrat eine linienförmige Gestalt aus. Die Veränderungen der Materialeigenschaft werden bevorzugt auf einer Erzeugungsebene erzeugt, die bevorzugt parallel zur Hauptoberfläche verläuft. Die linienförmige Gestalt erstreckt sich bevorzugt zumindest abschnittsweise geradlinig oder gebogen. Die Kristallgitterebenen des Spendersubstrats sind gegenüber der Erzeugungsebene bevorzugt geneigt ausgerichtet. Die linienförmige Gestalt, insbesondere zumindest der sich geradlinig erstreckende Abschnitt oder der sich gebogen erstreckende Abschnitt, ist gegenüber einer sich an der Schnittstelle zwischen der Erzeugungsebene und der Kristallgitterebene ergebenden Schnittlinie bzw. Schnittgeraden geneigt, wodurch die veränderte Materialeigenschaft das Spendersubstrat in Form von unterkritischen Rissen einreißt. Bevorzugt erfolgt der Schritt des Abtrennens der Festkörperschicht durch Einleiten einer äußeren Kraft in das Spendersubstrat zum Verbinden der unterkritischen Risse oder es wird so viel Material auf der Erzeugungsebene mittels der Lasterstrahlung verändert, dass sich unter Verbindung der unterkritischen Risse die Festkörperschicht von dem Spendersubstart ablöst. Die Hauptoberfläche wird hierbei bevorzugt als ideal ebene Oberfläche angesehen/definiert.

Dieses Verfahren ist vorteilhaft, da dadurch, dass die linienförmige Gestalt gegenüber einer sich an der Schnittstelle zwischen der Erzeugungsebene und der Kristallgitterebene ergebenden Schnittlinie bzw. Schnittgeraden geneigt ist, das Risswachstum senkrecht zur Schreibrichtung begrenzt wird. Die Modifikationen je Schreiblinie werden somit nicht in denselben Kristallgitterebenen erzeugt. Z.B. die ersten 1-5% der Modifikationen je Schreiblinie können somit nur noch einen Bruchteil, insbesondere weniger als 75% oder weniger als 50% oder weniger als 25% oder weniger als 10% oder keine Kristallgitterebenen, der letzten 1-5% der Modifikationen derselben Schreiblinie schneiden. Die Schreiblinie ist hierbei bevorzugt länger als 1cm oder länger als 10cm oder länger als 20cm oder bis zu 20cm lang oder bis zu 30cm lang oder bis zu 40cm lang oder bis zu 50cm lang. Er werden somit je Schreiblinie deutlich weniger Modifikationen in denselben Kristallgitterebenen erzeugt, wodurch eine Rissausbreitung entlang dieser Kristallgitterebenen begrenzt wird. Geneigt ist hierbei als nicht parallel oder nicht überlagernd zu verstehen und kann somit zum Beispiel schon ab einem Winkel von 0,05° vorliegen, wobei sich auch bei sehr kleinen Winkeln, insbesondere unter 1°, über die Erstreckungslänge der linienförmigen Gestalt voneinander verschiedene Kristallgitterebenen, insbesondere Gleitebenen, durch die Modifikation bzw. Modifikationen lokal geschnitten bzw. modifiziert bzw. verändert werden.

Dies führt zu einem zweiten Vorteil, nämlich dass die Schreibrichtung nicht zwingend derart ausgeführt werden muss, dass die weiteren erzeugten Risse die zuletzt erzeugten Risse überlagern müssen. Es ist nunmehr auch möglich, dass die Schreibrichtung entgegengerichtet ist. Aufgrund der möglichen Kürze der Risse erfolgt nämlich kein Abschatten durch die zuletzt erfolgten Risse. Dies ermöglicht es, dass trotz der entgegengerichteten Schreibrichtung z.B. Linienabstände von weniger als 100µm, insbesondere von weniger als 75µm oder von weniger als 50µm oder von weniger als 30 µm oder von weniger als 20 µm oder von weniger als 10 µm oder von weniger als 5 µm oder von weniger als 2 µm, realisiert werden können.

Als Veränderung der Materialeigenschaft kann hierbei bevorzugt das Erzeugen einer Materialmodifikation bzw. das Erzeugen eines Kristallgitterdefekts, insbesondere das Bewirken eines lokal begrenzten Phasenwechsels, verstanden werden.

Gemäß einer ersten bevorzugten Ausführungsform ist die linienförmige Gestalt bzw. Schreiblinie gegenüber der Schnittlinie in einem Winkelbereich zwischen 0,05° und 87°, insbesondere in einem Winkelbereich zwischen 3° oder 5° und 60° und bevorzugt zwischen 10° und 50°, insbesondere zwischen 10° und 30°, wie z.B. zwischen 12° und 20° oder zwischen 13° und 15°, oder zwischen 20° und 50°, insbesondere zwischen 25° und 40° oder zwischen 30° und 45° oder zwischen 28° und 35°, geneigt. Diese Lösung ist vorteilhaft, da die Neigung so groß ist, dass ausreichend viele unterschiedliche Kristallgitterebenen Bestandteil jeder weiteren Modifikation derselben linienförmigen Gestalt bzw. Schreiblinie sind.

Gemäß einer weiteren bevorzugten Ausführungsform wird so viel Material des Spendersubstrats unter Ausbildung einer linienförmigen Gestalt oder mehrerer linienförmiger Gestalten verändert, dass sich aus den infolge der Festkörperschichtenabtrennung freigelegten Enden der einzelnen Kristallgitterebenen und den Materialveränderungen Moirémuster ergeben, wobei hierzu eine Vielzahl sich linienförmig und bevorzugt geradlinig erstreckender und parallel zueinander ausgerichteter Materialveränderungsbereiche erzeugt werden.

Eine linienförmige Gestalt ist hierbei bevorzugt als Punktmenge anzusehen, die eine gerade oder gebogene Linie ausbildet. Die Abstände zwischen den Zentren der einzelnen Punkte liegen dabei bevorzugt weniger als 250µm, insbesondere weniger als 150 µm oder weniger als 50 µm oder weniger als 15µm oder weniger als 10µm oder weniger als 5µm oder weniger als 2µm, auseinander.

Bevorzugt werden mehrere linienförmige Gestalten auf derselben Erzeugungsebene erzeugt, bevorzugt sind zumindest mehrere der linienförmigen Gestalten im gleichen Abstand zueinander angeordnet. Bevorzugt können die linienförmigen Gestalten bogenförmig insbesondere kreisbogenförmig oder gerade ausgebildet sein.

Gemäß einer weiteren bevorzugten Ausführungsform kann das Verfahren den Schritt des Bewegens des Festkörpers relativ zum Laser aufweisen, wobei der Laser zur definierten Fokussierung der Laserstrahlung und/oder zur Anpassung der Laserenergie bevorzugt kontinuierlich in Abhängigkeit von mindestens einem Parameter und bevorzugt einer Vielzahl an Parametern, insbesondere mindestens zwei Parametern, eingestellt wird, wobei ein Parameter bevorzugt der Grad der Dotierung des Festkörpers an einem vorbestimmten Ort oder in einem vorbestimmten Bereich, insbesondere im Inneren, des Festkörpers, insbesondere beabstandet zur Festkörperoberfläche, ist.

Gemäß einer weiteren bevorzugten Ausführungsform ist ein zusätzlicher oder alternativer Parameter der Grad der Dotierung des Festkörpermaterials, der bevorzugt durch die Analyse von zurückgestreutem Licht (bevorzugt Raman-Streuung) bestimmt wird, wobei das zurückgestreute Licht eine andere Wellenlänge oder einen anderen Wellenlängenbereich aufweist als zum Auslösen der Zurückstreuung definiert eingestrahltes Licht, wobei ein Raman-Instrument bevorzugt Bestandteil der Vorrichtung ist und der Grad der Dotierung bevorzugt mittels des Raman-Instruments bestimmt wird, wobei ein oder mehrere oder alle dieser Parameter bevorzugt mittels eines gemeinsamen Detektionskopfes, insbesondere zeitgleich, erfasst werden. Die Ramanspektroskopie wird bevorzugt ebenfalls bei Gläsern, Saphir, Aluminiumoxidkeramik eingesetzt. Das Raman-Verfahren ist vorteilhaft, da es in der Tiefe des Materials misst, aber nur von einer Seite, keine hohe Transmission benötigt und durch einen Fit an das Raman-Spektrum die Ladungsträgerdichte/Dotierung ausgibt, die mit den Laserparametern korreliert werden kann.

Ein zusätzlicher oder alternativer Parameter ist gemäß einer weiteren bevorzugten Ausführungsform der Grad der Dotierung des Festkörpers an einem vorbestimmten Ort oder in einem vorbestimmten Bereich, insbesondere im Inneren, des Festkörpers, insbesondere beabstandet zur Festkörperoberfläche. Bevorzugt wird der Grad der Dotierung derart mit Ortsinformationen verknüpft, dass eine Behandlungskarte entstehet bzw. ortsaufgelöste Behandlungsanweisung bereitgestellt werden, die ortsabhängig die Laserparameter, insbesondere Laserfokus und/oder Laserenergie, und/oder weitere Maschinenparameter, insbesondere die Vorschubgeschwindigkeit, vorgibt bzw. vorgeben.

Der Grad der Dotierung wird gemäß einer weiteren bevorzugten Ausführungsform durch die Analyse von zurückgestreutem Licht mit einer unelastischen Streuung (Raman-Streuung) bestimmt, wobei das zurückgestreute Licht eine andere Wellenlänge oder einen anderen Wellenlängenbereich aufweist als zum Auslösen der Zurückstreuung definiert eingestrahltes Licht, wobei das zurückgestreute Licht von dem vordefinierten Ort aus oder von dem vorbestimmten Bereich aus zurückgestreut wird.

Diese Ausführungsform ist vorteilhaft, da im Laserverfahren, insbesondere auf SiC (aber auch anderen Materialien) der Prozess ortsangepasst geführt werden muss (z.B. andere Laserenergie, etc.). Es wurde erkannt, dass z.B. bei SiC hierfür insbesondere die Dotierung entscheidend ist, da diese die Transparenz des Materials für die Bearbeitungswellenlänge ändert und höhere Laserenergien erforderlich macht.

Der Grad der Dotierung wird gemäß einer weiteren bevorzugten Ausführungsform mittels einer ellipsometrischen Messung (z.B. Müller-Matrix-Ellipsometrie mit Rückseitenreflexion) bestimmt. Die ellipsometrische Messung beruht bevorzugt auf einer optischen Transmission des Materials.

Gemäß einer weiteren bevorzugten Ausführungsform wird der Grad der Dotierung mittels einer rein optisch kalibrierten Transmissionsmessung bestimmt, wobei die Kalibrierung mittels Hall-Messung und 4-Punkt-Messung bewirkt wird. Dieses Verfahren kann ebenfalls die Dotierung/Zahl der freien Ladungsträger im Material ermitteln, die dann die für den Prozess benötigte Laserenergie ermitteln lässt.

Der Grad der Dotierung wird gemäß einer weiteren bevorzugten Ausführungsform mittels einer Wirbelstrommessung bestimmt, wobei bevorzugt Leitfähigkeitsunterschiede im Festkörpermaterial bestimmt und ausgewertet werden.

Bei Wirbelstrommessungen bzw. bei Verwendung von Wirbelstromsensoren bzw. in der Wirbelstrommesstechnik wird bevorzugt eine Sende- und Empfangsspule genutzt, um lokale Leitfähigkeitsunterschiede zu detektieren. In der Sendespule wird eine hochfrequentes elekromagnetisches primäres Wechselfeld erzeugt. Im leitfähigen Material werden dann Wirbelströme (lokal fliessende Ströme) induziert, die wiederum ein sekundäres entgegen gerichtetes elektromagnetisches Wechselfeld hervorrufen. Die Überlagerung dieser Felder kann gemessen, separiert und ausgewertet werden. Damit können verschiedene Qualitätsmerkmalen (Schichtdicke, dem Schichtwiderstand, der Materialhomogenität) hauptsächlich dünner Leitschichten aber auch von Bulkmaterial gemessen werden. In Transmissionsanordnung (Prüfkörper zwischen Sende- und Empfangsspule) werden optimale Auflösungen erreicht, aber auch die Anordnung beider Spulen auf einer Probenseite für Reflexionsmessungen ist möglich. Durch angepasstes Design der Spulen und Frequenzwahl können unterschiedliche Eindringtiefen und Sensitivitäten genutzt werden.

Grundsätzlich gibt es somit eine Vielzahl von Messmethoden, mit denen im Prinzip die Dotierung gemessen werden kann. Wichtig ist hier ein schnelles, kontaktloses, zerstörungsfreies Verfahren.

Ein erster Parameter kann hierbei die mittlere Brechzahl des Materials des Spendersubstrats oder die Brechzahl des Materials des Spendersubstrats in dem Bereich des Spendersubstrats sein, der zur Erzeugung einer definierten Materialveränderung von Laserstrahlung zu durchqueren ist und
ein zweiter oder alternativer erster Parameter kann hierbei die Bearbeitungstiefe in dem Bereich des Spendersubstrats sein, der zur Erzeugung einer definierten Materialveränderung von Laserstrahlung zu durchqueren ist. Der erste Parameter wird bevorzugt mittels eines Brechzahlbestimmungsmittels, insbesondere mittels spektraler Reflektion, bestimmt und/oder der zweite Parameter wird bevorzugt mittels eines Topografiebestimmungsmittels, insbesondere mittels eines konfokal-chromatischen Distanzsensors, bestimmt.

Gemäß einer weiteren bevorzugten Ausführungsform ist ein erster Parameter die mittlere Brechzahl des Materials des Festkörpers oder ist die Brechzahl des Materials des Festkörpers in dem Bereich des Festkörpers, der zur Erzeugung einer definierten Modifikation von Laserstrahlen zu durchqueren ist, oder ist die Transmission des Festkörpers an definierten Stellen des Festkörpers und bevorzugt für eine definierte Festkörpertiefe. Ein zweiter oder alternativer erster Parameter ist gemäß einer weiteren bevorzugten Ausführungsform die Bearbeitungstiefe in dem Bereich des Festkörpers, der zur Erzeugung einer definierten Modifikation von Laserstrahlen zu durchqueren ist. Der erste Parameter wird gemäß einer weiteren bevorzugten Ausführungsform mittels eines Brechzahlbestimmungsmittels, insbesondere mittels spektraler Reflexion, bestimmt und/oder der zweite Parameter wird mittels eines Topografiebestimmungsmittels, insbesondere mittels eines konfokal-chromatischen Distanzsensors, bestimmt.

Gemäß einer weiteren bevorzugten Ausführungsform ist ein erster Parameter die Vorschubrichtung, in der eine linienförmige Gestalt als Folge von Modifikationen in der Erzeugungsebene ausgebildet wird, insbesondere eine Hin- und/oder eine Rückfahrt. Somit kann ein erster Parameter die Laserparameter bei einer Hinfahrt und ein zweiter Parameter die Laserparameter bei einer Rückfahrt, insbesondere bei mäanderförmiger Bearbeitung mittels X-Y-Tisch, repäsentieren.

Daten zu den Parametern, insbesondere zu dem ersten Parameter und zu dem zweiten Parameter, werden gemäß einer weiteren bevorzugten Ausführungsform in einer Datenspeichereinrichtung bereitgestellt und zumindest vor der Erzeugung der Materialveränderung einer Steuerungseinrichtung zugeführt, wobei die Steuerungseinrichtung den Laser in Abhängigkeit vom jeweiligen Ort der zu erzeugenden Materialveränderung einstellt, wobei die Steuerungseinrichtung zur Einstellung des Lasers bevorzugt ebenfalls Distanzdaten zu einem Distanzparameter verarbeitet, wobei der Distanzparameter den Abstand des jeweiligen Ortes, an dem Laserstrahlung zur Erzeugung der Materialveränderung in das Spendersubstrat zum Zeitpunkt der Materialveränderung eingeleitet werden, gegenüber dem Laser wiedergibt, wobei die Distanzdaten mittels einer Sensoreinrichtung erfasst werden.

Daten zu den Parametern, insbesondere zu dem ersten Parameter und zu dem zweiten Parameter, werden gemäß einer weiteren bevorzugten Ausführungsform in einer Datenspeichereinrichtung bereitgestellt und zumindest vor der Erzeugung der Modifikationen einer Steuerungseinrichtung zugeführt, wobei die Steuerungseinrichtung die Laserbeaufschlagungseinrichtung in Abhängigkeit vom jeweiligen Ort der zu erzeugenden Modifikation einstellt.

Die zuvor genannte Aufgabe wird ebenfalls durch ein Verfahren zum Abtrennen von mindestens einer Festkörperschicht von einem Festkörper gelöst. Das Verfahren weist dabei bevorzugt die nachfolgenden Schritte auf: Durchführen eines Verfahrens gemäß einem der Ansprüche 1 bis 13 oder einem hierin beschriebenen Verfahren zum Erzeugen von Modifikationen in eine Festkörper und den Schritt des Einleitens einer äußeren Kraft in den Festkörper zum Erzeugen von Spannungen in dem Festkörper und/oder den Schritt des Erzeugens einer inneren Kraft in dem Festkörper, wobei die äußere und/oder innere Kraft so stark ist, dass daraus eine Rissausbreitung entlang des Ablösebereichs resultiert. Durch die innere und/oder äußere Kraft wird ein die unterkritischen Risse verbindender Hauptriss bewirkt bzw. ausgelöst.

Gemäß einer weiteren bevorzugten Ausführungsform wird zum Einleiten der äußeren Kraft eine Aufnahmeschicht an einer freiliegenden Oberfläche der abzutrennenden Festkörperschicht angeordnet, wobei die Aufnahmeschicht ein Polymermaterial, insbesondere PDMS, aufweist und die Aufnahmeschicht zum, insbesondere mechanischen, Erzeugen von Spannungen in dem Festkörper thermisch beaufschlagt wird, wobei die thermische Beaufschlagung ein Abkühlen der Aufnahmeschicht auf eine Temperatur unterhalb der Umgebungstemperatur, insbesondere auf eine Temperatur unterhalb von 0° oder auf eine Temperatur unterhalb von -10° oder auf eine Temperatur zwischen -20° und -200°C, darstellt, wobei die Abkühlung derart erfolgt, dass das Polymermaterial der Aufnahmeschicht einen Glasübergang vollzieht und wobei sich durch die Spannungen ein Riss in dem Festkörper entlang des Ablösebereichs ausbreitet, der die erste Festkörperschicht von dem Festkörper abtrennt und/oder zum Einleiten der äußeren Kraft der Festkörper mit Schall, insbesondere Ultraschall, beaufschlagt wird und/oder zum Einleiten der äußeren Kraft die umlaufende Oberfläche des Festkörpers auf Höhe der Ablöseebene thermisch und/oder spanend beaufschlagt wird, und/oder zum Erzeugen von inneren Kräften eine solchen Anzahl an Modifikationen im Inneren des Festkörpers erzeugt wird, dass sich die unterkritischen Risse zu einem die Festkörperschicht abtrennenden Riss verbinden.

Weiterhin bezieht sich ein Gegenstand auf eine Festkörperschicht, insbesondere hergestellt nach einem Verfahren gemäß Anspruch 14. Die Festkörperschicht bzw. der Wafer weist bevorzugt SiC auf oder besteht daraus. Bevorzugt bildet die Festkörperschicht eine Oberfläche aus, wobei die Oberfläche eine Topografie ausbildet, wobei die Topografie längliche zick-zack-förmige oder wellenartige Erhebungen aufweist, wobei sich die länglichen zick-zack förmigen oder wellenartigen Erhebungen mehrheitlich und jeweils in ihrer Gesamtheit in einer Richtung oder mehreren Richtungen erstrecken, die von einer Richtung, die parallel zu den Kristallgitterebenen und parallel zur Oberfläche steht verschieden ist, insbesondere dazu in einem Winkel zwischen 2° und 30°, insbesondere zwischen 3° und 15°, insbesondere zwischen 4° und 9°, geneigt ist, wobei die mittlere Höhe der zick-zack-förmigen oder wellenartigen Erhebungen oder die maximale Höhe der zick-zack-förmigen oder wellenartigen Erhebungen, gegenüber der tiefsten Stelle der Oberfläche weniger als 100 µm, insbesondere weniger als 75µm oder weniger als 50µm oder weniger als 30µm, beträgt. Als tiefste Stelle wird dabei bevorzugt nur eine Stelle angesehen, die mindestens 1mm oder mindestens 5mm oder mindestens 10mm vom Rand der Festkörperschicht bzw. des Wafers beabstandet ist. Bevorzugt handelt es sich bei der Festkörperschicht um eine von einem SiC-Ingot oder SiC-Boules abgetrennten Wafer.

Diese Lösung ist vorteilhaft, da eine Festkörperschicht erzeugt wird, deren Oberflächenstruktur das unkontrollierte Ausbreiten von Rissen reduziert bzw. verhindert.

Weiterhin bezieht sich ein Gegenstand auf eine Festkörperschicht, insbesondere hergestellt nach einem Verfahren gemäß Anspruch 14. Die Festkörperschicht weist dabei bevorzugt SiC auf oder besteht daraus. Die Festkörperschicht bildet eine Oberfläche aus, wobei als Bestandteil der Oberfläche und entlang zueinander paralleler und entlang der Oberfläche erstreckender und voneinander beabstandeter Erstreckungsrichtungen phasenumgewandelte Materialbestandteile vorliegen, wobei die zueinander parallelen und voneinander beabstandeten Erstreckungsrichtungen gegenüber einer Richtung, die parallel zu den Kristallgitterebenen und parallel zur Oberfläche orientiert ist, in einem Winkel zwischen 2° und 30°, insbesondere zwischen 3° und 15°, geneigt sind.

Bevorzugt bildet die Oberfläche eine Topografie aus, wobei die Topografie längliche zick-zack-förmige Erhebungen aufweist, wobei sich die länglichen zick-zack förmigen Erhebungen mehrheitlich und jeweils in ihrer Gesamtheit in einer Richtung oder mehreren Richtungen erstrecken, die von einer Richtung, die parallel zu den Kristallgitterebenen und parallel zur Oberfläche steht verschieden ist, insbesondere dazu in einem Winkel zwischen 2° und 30°, insbesondere zwischen 3° und 15°, insbesondere zwischen 4° und 9°, geneigt ist, wobei die mittlere Höhe der zick-zack-förmigen Erhebungen oder die maximale Höhe der zick-zack-förmigen Erhebungen, gegenüber der tiefsten Stelle der Oberfläche weniger als 100 µm, insbesondere weniger als 75µm oder weniger als 50µm oder weniger als 30µm, beträgt.

Weitere Vorteile, Ziele und Eigenschaften des beschriebenen Gegenstands oder der beschriebenen Gegenständewerden anhand nachfolgender Beschreibung anliegender Zeichnungen erläutert, in welchen beispielhaft das Trennverfahren dargestellt ist. Bauteile oder Elemente, die in dem Verfahren bevorzugt eingesetzt werden und/oder welche in den Figuren wenigstens mehrheitlich hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1a: eine erste schematische Darstellung des Zusammenhangs zwischen Schreiblinie und polarisierter Laserstrahlung;
- Fig. 1b: eine zweite schematische Darstellung des Zusammenhangs zwischen Schreiblinie und polarisierter Laserstrahlung;
- Fig. 2a-e: verschiedene exemplarischer Darstellungen unterschiedlicher Polarisationen,
- Fig. 3a: eine dritte schematische Darstellung des Zusammenhangs zwischen Schreiblinie und polarisierter Laserstrahlung;
- Fig. 3b: eine vierte schematische Darstellung des Zusammenhangs zwischen Schreiblinie und polarisierter Laserstrahlung;
- Fig. 4: ein Spendersubstrat mit gegenüber der Längsachse in einem Winkel von ungleich 90° ausgerichteten Kristallgitterebenen und erzeugten Laserschreiblinien,
- Fig. 5: ein weiteres Spendersubstrat mit gegenüber der Längsachse in einem Winkel von ungleich 90° ausgerichteten Kristallgitterebenen und erzeugten Laserschreiblinien, wobei die Ausrichtung der Laserschreiblinien bzw. linienartigen Gestalt mittels Ebenen definiert ist,
- Fig. 6: dass die Modifikationen einer linienförmigen Gestalt eine Vielzahl unterschiedlicher Kristallgitterebenen schneiden,
- Fig. 7: ein Beispiel eines Kristallgitters mit Gleitebene für 4HSiC,
- Fig. 8a: ein Beispiel eines Kristallgitters mit Gleitebene 110 für Si,
- Fig. 8b: ein Beispiel eines Kristallgitters mit Gleitebene 100 für Si,
- Fig. 8c: ein Beispiel eines Kristallgitters mit Gleitebene 111 für Si,
- Fig. 9a-10a: die Veränderung der Neigung der linienförmigen Gestalt gegenüber den Enden der Kristallebene, wenn das Spendersubstrat mittels einer Rotationseinrichtung unter einer Lasereinrichtung vorbeibewegt wird,
- Fig. 10b: eine Draufsicht auf eine exemplarische Rotationseinrichtung,
- Fig. 10c: eine Seitenansicht eine Bearbeitungsanlage, wobei die Bearbeitungsanlage ein bevorzugt linear verfahrbares Laserelement und eine Rotationseinrichtung mit einer Vielzahl darauf angeordneter Spendersubstrate aufweist,
- Fig. 11a: eine schematische Darstellung der theoretischen Zusammenhänge der Formel (d-x)/x;
- Fig. 11b: eine typische Oberflächenstruktur einer Festkörperoberfläche einer abgetrennten Festkörperschicht,
- Fig. 11c: eine Darstellung von Schreiblinien, die infolge unterschiedlich definierter Parameter erzeugt wurden,
- Fig. 11d: verschiedene zick-zackförmige Linien,
- Fig. 12: eine schematische Darstellung einer Erzeugung von mechanischen Spannungen im Inneren des Festkörpers zur Begrenzung der Ausbreitung der unterkritischen Risse,
- Fig. 13: eine weitere schematische Darstellung einer Erzeugung von mechanischen Spannungen im Inneren des Festkörpers zur Begrenzung der Ausbreitung der unterkritischen Risse,
- Fig. 14a-c: optische Mittel zur Veränderung der Laserstrahleigenschaften.

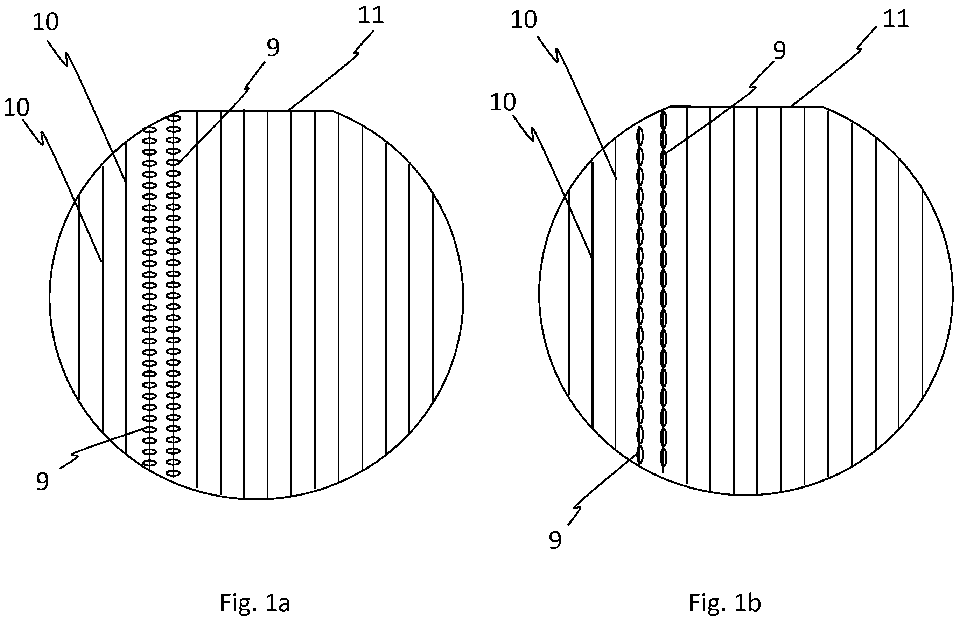

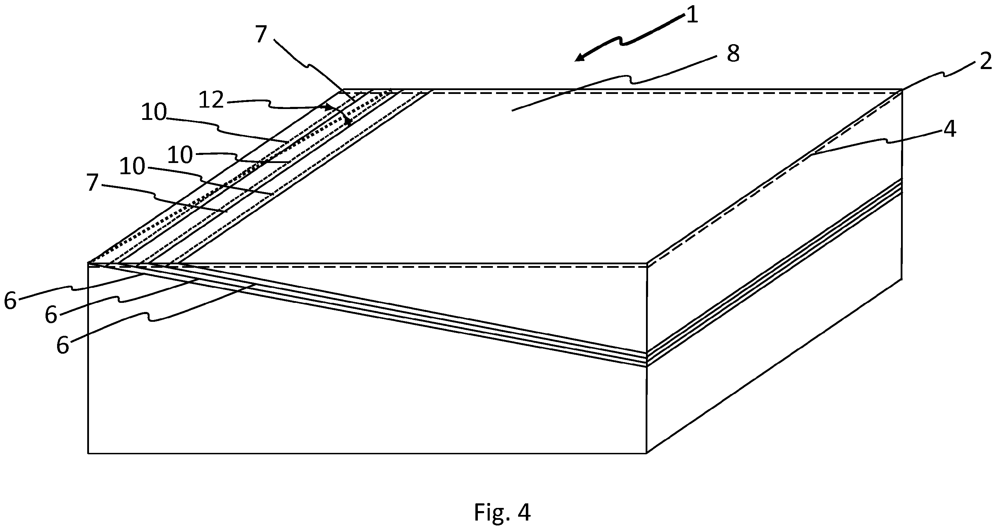

Fig. 1a zeigt eine schematische Darstellung eines Festkörpers 1 während einer Behandlung, insbesondere der Erzeugung von Modifikationen 9 im Inneren des Festkörpers 1. Die Modifikationen 9 stellen dabei bevorzugt mittels Mehrphotonenanregung erzeugte Phasenumwandlungen des Festkörpermaterials, insbesondere SiC, dar. Gemäß dieser Darstellung werden die Modifikationen 9 derart erzeugt, dass sie voneinander beabstandet sind. Diese Lösung ist vorteilhaft, da dadurch eine bereits erzeugte Modifikation 9 die Absorption der Laserstrahlen nicht oder nur geringfügig verändert bzw. beeinflusst. Die Modifikationen 9 werden bevorzugt in Form von linienförmigen Gestalten bzw. Schreiblinien 103 erzeugt. Die Schreiblinien 103 sind dabei bevorzugt geradlinig ausgebildet. Die Schreiblinien 103 sind gemäß dieser Darstellung bevorzugt parallel zur Schnittlinie 10 orientiert. Die Schnittlinie 10 resultiert dabei bevorzugt aus einer Schnittstelle zwischen der Erzeugungsebene 4 und der Kristallgitterebene 6 (vgl. Fig. 4). Weiterhin ist gemäß dieser Darstellung erkennbar, dass die Modifikationen 9 stets in derselben Richtung ausgerichtet sind. Dies resultiert daraus, dass die Laserstrahlung definiert polarisiert ist. Gemäß Fig. 1a wird somit eine erste Polarisation verwendet, während gemäß Fig. 1b eine andere Polarisation verwendet wird. Es resultieren aus den unterschiedlichen Polarisationen bevorzugt auch unterschiedliche Schadmuster.

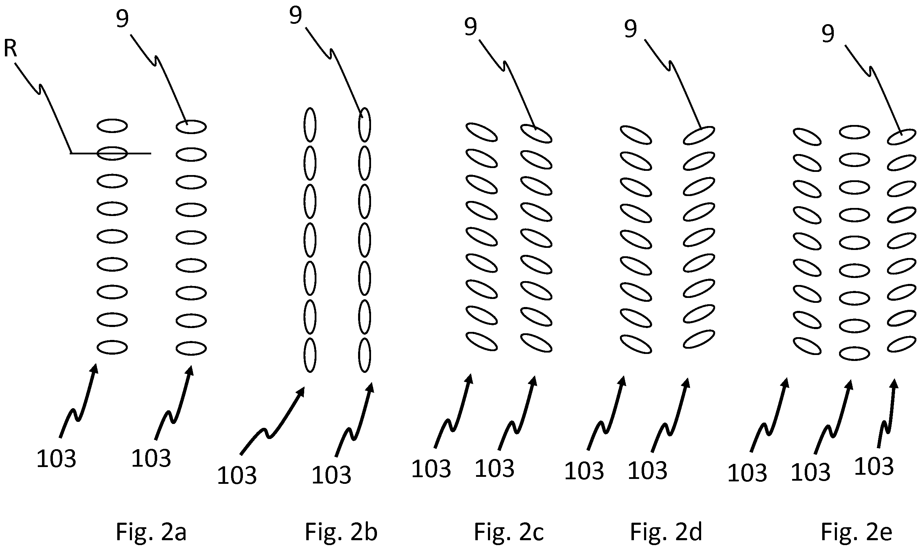

Die Figuren 2a bis 2e zeigen mehrere Beispiele für unterschiedlich polarisierte Laserstrahlung. Das Beispiel der Fig. 2a entspricht dabei dem Beispiel aus Fig. 1a und das Beispiel aus Fig. 2b entspricht dabei dem Beispiel aus Fig. 1b.

Ferner kann die Polarisation für mehrere oder alle Schreiblinien 103 zum Ausbilden eines definierten Winkels gegenüber der Längserstreckungsrichtung der Schreiblinie 103 eingestellt sein. Der Winkel kann dabei bevorzugt zwischen 0° und 90°, insbesondere zwischen 5° und 85°, insbesondere zwischen 15° und 75°, insbesondere zwischen 30° und 60°, insbesondere zwischen 40° und 50° oder bei 45° oder um 45°, liegen. Dies wird z.B. durch die Figuren 2c bis 2e gezeigt.

Fig. 2d zeigt, dass die Modifikationen 9 unterschiedlicher Schreiblinien 103 unterschiedlich orientiert sein können. Es ist ebenfalls möglich, dass die Modifikationen 9 einer Schreiblinie abschnittsweise oder punktuell unterschiedlich definiert polarisiert sein können.

Fig. 2e zeigt eine Variante, gemäß der mehr als 2, insbesondere 3 oder mehr als 3 unterschiedliche polarisierte Schreiblinien 103 erzeugt werden.

Es ist ebenfalls denkbar, dass die Ausrichtung R einzelner oder mehrerer Modifikationen oder der Mehrzahl der Modifikationen einer linienförmigen Gestalt voneinander abweichen. Insbesondere bei gebogenen oder spiralförmigen linienförmigen Gestalten kann die Ausrichtung R der Modifikationen voneinander abweichen. Die Ausrichtung R der Modifikationen kann sich daher z.B. kontinuierlich oder stufenweise bzw. blockweise ändern, wobei ein Block bevorzugt aus mehreren, insbesondere 2-200 oder 2 bis 100 oder 2 bis 50, Modifikationen besteht.

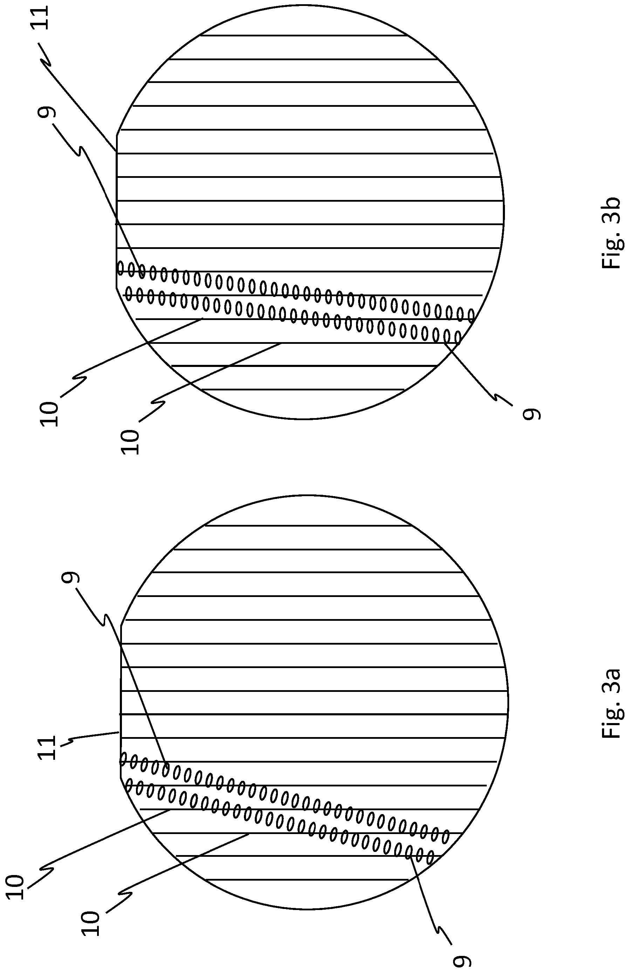

Fig. 3a zeigt, dass die Schreiblinien gegenüber den Schnittlinien 10 geneigt sein können. Je nach Ausrichtung der Polarisation gegenüber der Schreibrichtung können die so erzeugten Modifikationen 9 gegenüber der Schnittline 10 geneigt ausgerichtet sein. Fig. 3b zeigt, dass die Modifikationen in einer 90° Ausrichtung zur Schnittlinie 10 erzeugt werden können, während die Schreiblinie gegenüber der Schnittline 10 geneigt bzw. in der Ebene eingedreht ist.

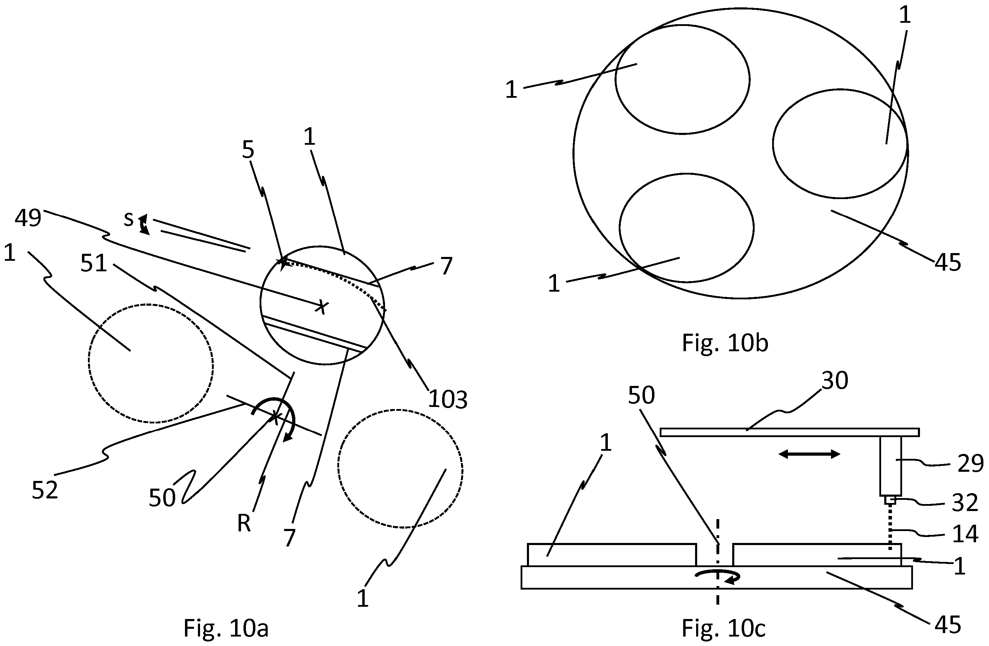

Fig. 4 zeigt schematisch, dass Laserstrahlung 14 (vgl. Fig. 10c) eines Lasers über eine Hauptoberfläche 8 in das Innere des Festkörpers 1 zum Verändern der Materialeigenschaften des Festkörpers 1 im Bereich von mindestens einem Laserfokus eingebracht wird, wobei der Laserfokus durch von dem Laser emittierten Laserstrahlen des Lasers gebildet wird. Die Veränderung der Materialeigenschaft bildet durch Verändern des Eindringortes der Laserstrahlung in das Spendersubstrat 1 eine linienförmige Gestalt 103 aus, wobei die Veränderungen der Materialeigenschaft auf mindestens einer, insbesondere derselben, Erzeugungsebene 4 erzeugt werden. Die Kristallgitterebenen 6 des Spendersubstrats 1 sind dabei gegenüber der Erzeugungsebene 4 geneigt, insbesondere in einem Winkel zwischen 0,1 ° und 9° bevorzugt von 2° oder 4° oder 8°, ausgerichtet. Die linienförmige Gestalt 103 bzw. Schreiblinie ist dabei gegenüber einer sich an der Schnittstelle zwischen der Erzeugungsebene 4 und der Kristallgitterebene 6 ergebenden Schnittlinie 10 geneigt. Durch die veränderte Materialeigenschaft reißt das Spendersubstrat 1 in Form von unterkritischen Rissen ein. Ein Schritt des Abtrennens der Festkörperschicht 2 durch Einleiten einer äußeren Kraft in das Spendersubstrat 1 zum Verbinden der unterkritischen Risse ist hierbei nicht dargestellt. Alternativ dazu kann so viel Material auf der Erzeugungsebene 4 mittels der Lasterstrahlung verändert werden, dass sich unter Verbindung der unterkritischen Risse die Festkörperschicht 2 von dem Spendersubstart 1 ablöst. Die Erzeugungsebene 4 ist bevorzugt parallel zur Hauptoberfläche 8.

Die Bearbeitung findet in Form von Erzeugung linienförmiger Gestalten 103 bzw. Schreiblinien bzw. Linien statt, die durch Setzen einzelner Laserschüsse in einem definierten Abstand gebildet werden.

Konkret ist z.B. die Herstellung eines Wafers aus Siliziumkarbid, insbesondere vom Polytyp 4H mit einer 0001 Oberfläche mit/ohne Dotierung mit einem off-angle in Kristallachse von >0° (Industriestandard sind 4° oder 8° - um die Richtung einer Hauptachse), möglich. Da die Gleitebene der hexagonalen Kristallstruktur parallel zur 0001 Ebene verläuft, ergibt sich eine Schnittgerade der 0001 Kristallebene mit der Waferoberfläche, da diese um den off-angle relativ dazu geneigt ist.

Grundüberlegung des neuen Verfahrens ist es somit, dass die Bearbeitungsrichtung der Laserlinien 103 von der Richtung dieser Schnittgeraden abweicht. Ebenso soll die Bearbeitungsrichtung bevorzugt nicht entlang einer der Hauptrichtungen des Kristalls oder entlang der Schnittgeraden der bevorzugten Gleitebene des Kristalls mit der Oberfläche des Kristalls verlaufen.

Ferner ist z.B. die Herstellung eines Wafers aus Siliziumkarbid vom Polytyp 4H möglich. Siliziumkarbid vom Polytyp 4H weist ein hexagonales Kristallsystem mit einer Wurtzit-Struktur und einer sechsfachen-Symmetrie in der 0001 Ebene auf. Dementsprechend findet sich alle 60° eine neue Hauptachse des Kristalls. Wenn die Oberfläche durch die der Bearbeitungslaser in das zu bearbeitende Materialstück eindringt, entlang der 0001-Ebene geschnitten ist, so findet sich die sechsfache Symmetrie bei Rotation um die Oberflächennormale wieder. Hier ergibt sich dann eine Linienschreibrichtung, die um 30° zu den jeweiligen Hauptachsen rotiert und damit zwischen zwei Hauptachsen orientiert ist. Auf diese Weise wird sichergestellt, dass die geschriebene Linie die Einheitszellen des Kristalls möglichst kreuzt und sich Risse, die größere Bereiche umfassen und mehrere Einheitszellen auf einmal betreffen, schwerer ausbilden können. Siliziumkarbid vom Polytyp 4H wird oft in einem Off-Winkel von 4° relativ zur 0001-Ebene geschnitten, um Epitaxie-Schritte in der späteren Bearbeitung zu vereinfachen. Hierbei zeigt sich, dass die Projektion der Hauptachsen des Kristalls zueinander weiterhin nahezu 60° zueinander hat, weswegen 30°+/-3° bevorzugte Schreibwinkel für die Bearbeitung ist.

Ferner ist z.B. die Herstellung eines Wafers aus kubischem SiC (sogenannt 3C) möglich. Kubisches SiC verhält sich wie kubische Kristallsysteme, hat also als bevorzugte Gleitebene die 111-Ebene, woraus sich eine bevorzugte Linienschreibrichtung von 22,5°+/-3° ergibt.

Ferner ist z.B. die Herstellung eines Wafers aus Silizium mit einer 100 Oberfläche mit/ohne Dotierung mit einem off-angle der Kristallachse von 0° möglich.

Die bevorzugte Gleitebene für Silizium mit seiner kubischen Struktur (Diamantstruktur) ist die 111 Ebene welche die Waferoberfläche im 45° Winkel zu den Kristallhauptachsen schneidet. Daraus ergibt sich damit ein angestrebter Linienschreibwinkel von 22.5°+/-3° zu den Hauptachsen des Kristalls und der Schnittgeraden der Gleitebene mit der Waferoberfläche, die zueinander in 45° Winkel orientiert sind.

Da auch Silizium-Substrate mit einem Off-Angle geschnitten sein können, kann hier wieder ein anderer Bearbeitungswinkel bevorzugt sein. Bei einer Verkippung um eine Hauptachse um einen Winkel a wird an der Oberfläche des Substrats die Symmetrie von einer 4fachen zu einer 2fachen Symmetrie durch die Kippung gebrochen. Die projizierte Länge der Hauptachse um die nicht gekippt wird, skaliert dann proportional zu cos(a), was zu einer Veränderung des Idealwinkels zwischen Hauptachsen und Schnittgerade der Gleitebene mit der Oberfläche führt. Die aufgrund der Symmetriebrechung dann möglichen zwei Linienschreibwinkel b sind dann entweder b1= tan-1(cos a)/2 oder b2= tan-1(1/cos a)/2.

Für Galliumnitrid mit einer hexagonalen Wurtzit-Struktur mit einer 6-fachen Kristallsymmetrie in der 0001-Ebene deren bevorzugte Gleitebene die 0001-Ebene ist, ergibt sich aus dem daraus folgenden Winkel von 60° für die Hauptachsen des Kristalls eine bevorzugte Linienrichtung von 30°+/-3° zu den Hauptachsen.

Für Saphir - oder Aluminiumoxid mit einer hexagonalen Korund-Struktur mit einer 6-fachen Kristallsymmetrie in der 0001-Ebene ergibt sich aus dem daraus folgenden Winkel von 60° für die Hauptachsen des Kristalls eine bevorzugte Linienrichtung von 30°+/-3° zu den Hauptachsen für sog. C-Plane-Saphir.

Für A-Plane geschnittenen Saphir ist die Hauptachsenorientierung im 90°-Winkel, mit einer 180°-Symmetrie, woraus sich ein bevorzugter Linienschreibwinkel von 45°+/-3° ergibt.

C-Plane-Substrate von Saphir sind so geschnitten, dass sich an der Oberfläche die sechsfache Symmetrie zeigt und die Oberfläche mit der Gleitebene übereinstimmt, also ein Winkel von 30°+/-3° bevorzugt ist.

Für M-Plane geschnittenen Saphir ist die Hauptachsenorientierung im 90°-Winkel, mit einer 180°-Symmetrie, woraus sich ein bevorzugter Linienschreibwinkel von 45°+/-3° ergibt.

R-Plane-Saphir hat keine Rotationssymmetrie, aber Hauptachsprojektionen in 45° zur Projektionsgeraden der Gleitebene, weswegen auch hier 22,5°+/-3° Schreibrichtung bevorzugt ist.

Für Lithiumtantalat mit einer triklinen Struktur, die mit dem hexagonalen Kristallsystem verwandt ist, ergibt sich, abhängig von der Orientierung des Substrats eine Schreibrichtung zwischen 10°+/-3° und 45°+/-3° relativ zu den einzelnen Hauptachsen und ihrer Projektion in die Substratoberfläche.

Für Galliumarsenid mit einer Zinkblende-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats bzw. Spendersubstrats 1 mit einer 100-Oberfläche.

Für Galliumoxid mit einer monoklinen, kubischen Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Germanium mit einer Diamant-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/- 3° zu den Hauptachsen des Substrats mit einer 100-Oberfläche.

Für Indiumphosphid mit einer Zinkblende-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Yttrium-Aluminium-Granat mit einer kubischen Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

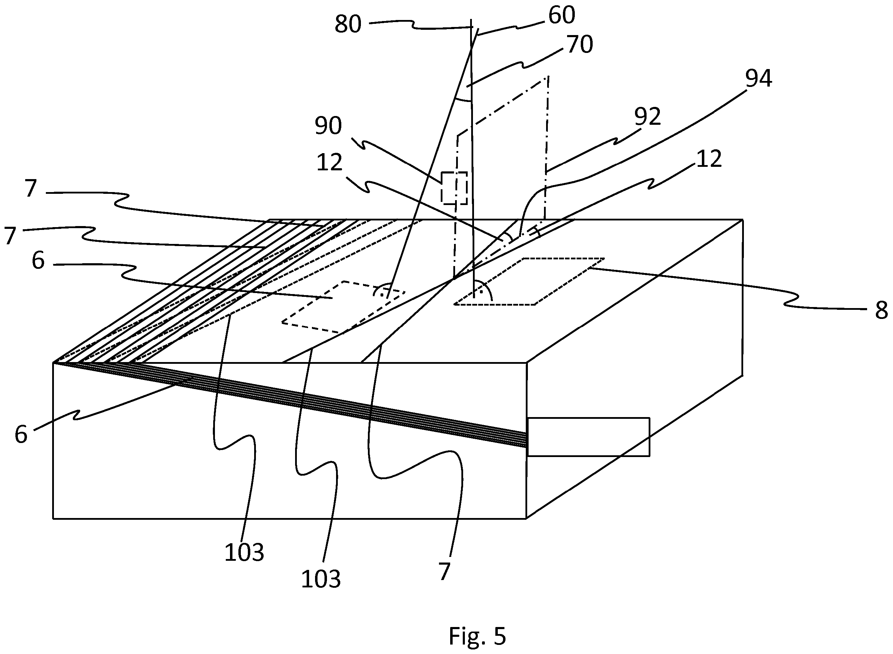

Fig. 5 zeigt einen Schritt des Verfahrens zum Abtrennen von mindestens einer Festkörperschicht 2 von einem Spendersubstrat 1 und eine geometrische Herleitung der Ausrichtung der Schreiblinie 103 bzw. der Ausrichtung der linienförmigen Gestalt.

Gemäß dieser Darstellung kann das Verfahren auch oder alternativ die nachfolgenden Schritte umfassen:
Bereitstellen des Spendersubstrats 1, wobei das Spendersubstrat 1 Kristallgitterebenen 6 aufweist, die gegenüber einer ebenen Hauptoberfläche 8 geneigt sind, wobei die Hauptoberfläche 8 das Spendersubstrat 1 in Längsrichtung L des Spendersubstarts 1 einerseits begrenzt, wobei sich eine Kritallgitterebenennormale 60 gegenüber einer Hauptoberflächennormalen 80 in eine erste Richtung neigt, Bereitstellen von mindestens einem Laser 29, Einbringen von Laserstrahlung 14 des Lasers in das Innere des Festkörpers bzw. Spendersubstrats 1 über die Hauptoberfläche 8 zum Verändern der Materialeigenschaften des Festkörpers im Bereich von mindestens einem Laserfokus, wobei der Laserfokus durch von dem Laser emittierten Laserstrahlen des Lasers gebildet wird, wobei die Veränderung der Materialeigenschaft durch Verändern des Eindringortes der Laserstrahlung in das Spendersubstrat 1 eine linienförmige Gestalt ausbildet, wobei sich die linienförmige Gestalt bevorzugt zumindest abschnittsweise geradlinig erstreckt und wobei die linienförmige Gestalt, insbesondere zumindest der sich geradlinig erstreckende Abschnitt, parallel zur Hauptoberfläche 8 erzeugt wird und sich dabei in einer zweiten Richtung erstreckt, die gegenüber der ersten Richtung in einem Winkel geneigt ist, der von 90° verschieden ist, wobei durch die veränderten Materialeigenschaft das Spendersubstrat 1 in Form von unterkritischen Rissen einreißt, Abtrennen der Festkörperschicht durch Einleiten einer äußeren Kraft in das Spendersubstrat zum Verbinden der unterkritischen Risse oder so viel Material auf der Erzeugungsebene mittels der Lasterstrahlung verändert wird, dass sich unter Verbindung der unterkritischen Risse die Festkörperschicht von dem Spendersubstart ablöst. Die Hauptoberfläche ist dabei bevorzugt Bestandteil der abgetrennten Festkörperschicht 2.

Die zweite Richtung ist dabei bevorzugt gegenüber der ersten Richtung in einem Winkelbereich zwischen 45° und 87°, insbesondere in einem Winkelbereich zwischen 70° und 80° und bevorzugt mit 76°, geneigt.

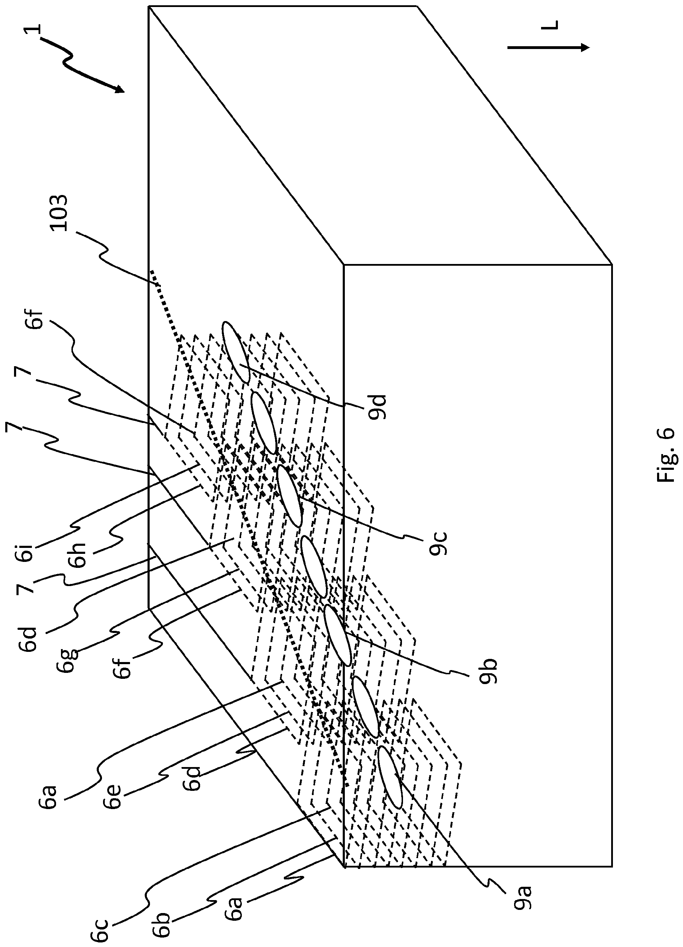

Fig. 6 zeigt, dass die linienförmige Gestalt 103 bzw. die Schreiblinie gegenüber den Enden der Kristallgitterebene oder wie in Fig. 5 gezeigt gegenüber einer sich an der Schnittstelle zwischen der Erzeugungsebene 4 und der Kristallgitterebene 6 ergebenden Schnittlinie 10 bzw. Schnittgeraden geneigt ist. Durch diese Ausrichtung wird das Risswachstum in Richtung der Kristallgitterebenen 6 (insbesondere Gleitebenen) begrenzt. Die Modifikationen 9 je Schreiblinie werden somit nicht in denselben Kristallgitterebenen 6 erzeugt. Z.B. die ersten 1-5% der Modifikationen je Schreiblinie 103 können somit nur noch einen Bruchteil, insbesondere weniger als 75% oder weniger als 50% oder weniger als 25% oder weniger als 10% oder keine Kristallgitterebenen, der letzten 1-5% der Modifikationen derselben Schreiblinie 103 in Substratlängsrichtung L schneiden. Dieser Zusammenhang wird insbesondere dadurch schematisch verdeutlicht, dass die Modifikation 9a die Kristallgitterebenen 6a-6c schneidet und die Modifikation 9b die Kristallgitterebenen 6a, 6d und 6e schneidet. Somit schneiden zwei Modifikationen 9a und 9b obwohl sie Bestandteil derselben linearen Gestalt 103 bzw. Schreiblinie sind, unterschiedliche Kristallgitterebenen. Ferner ist ersichtlich, dass z.B. die Modifikationen 9c und 9d bevorzugt andere, insbesondere mehrheitlich oder vollständig andere, Kristallgitterebenen schneidet als die Modifikation 9a.

Die auf der Hauptoberfläche 8 endenden Enden 7 der Kristallgitterebenen 6 bildet in einer mikroskopischen Schnittdarstellung bevorzugt eine Art Sägezahnmuster aus.

Die einzelnen Kristallgitterebenen 6 sind bevorzugt in einem Winkel zwischen 0,1° und 10°, insbesondere zwischen 2° und 9°, wie z.B. 4° oder 8°, gegenüber der Längsachse L geneigt. Bevorzugt sind die einzelnen Kristallgitterebenen des Spendersubstrats 1 parallel zueinander ausgerichtet.

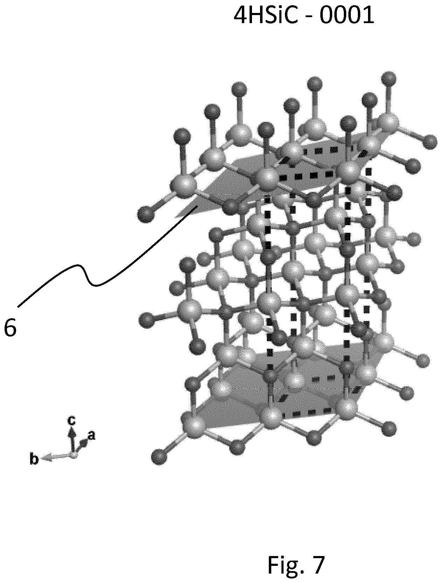

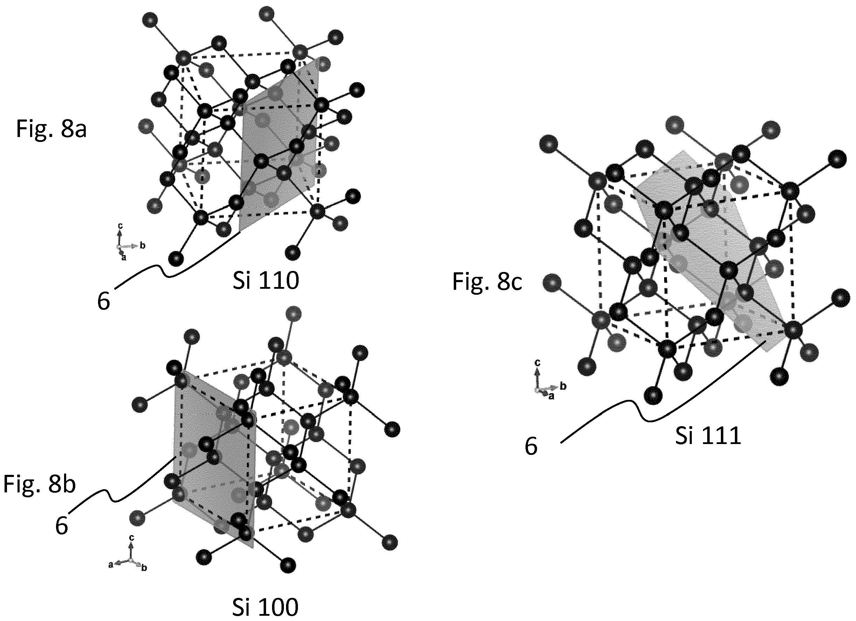

Fig. 7 zeigt ein Beispiel eines Kristallgitters mit Gleitebene für 4HSiC; Fig. 8a zeigt ein Beispiel eines Kristallgitters mit Gleitebene 110 für Si; Fig. 8b zeigt ein Beispiel eines Kristallgitters mit Gleitebene 100 für Si und Fig. 8c zeigt ein Beispiel eines Kristallgitters mit Gleitebene 111 für Si.

Bevorzugt handelt es sich bei den Kristallgitterebenen 6 um Gleitebenen eines bestimmten Typs. Ist die Kristallstruktur kubischflächenzentriert, dann ist die Gleitebene bevorzugt die Ebene {111} und die Gleitrichtung die Richtung <110>. Ist die Kristallstruktur kubischraumzentriert, dann ist die Gleitebene bevorzugt die Ebene {110} und die Gleitrichtung die Richtung <111> oder die Gleitebene ist bevorzugt die Ebene {112} und die Gleitrichtung ist die Richtung <111> oder die Gleitebene ist bevorzugt die Ebene {123} und die Gleitrichtung ist die Richtung <111>. Ist die Kristallstruktur hexagonal, dann ist die Gleitebene bevorzugt die Ebene {0001} und die Gleitrichtung die Richtung <1120> oder die Gleitebene ist bevorzugt die Ebene {1010} und die Gleitrichtung ist die Richtung <1120> oder die Gleitebene ist bevorzugt die Ebene {1011} und die Gleitrichtung ist die Richtung <1120>.

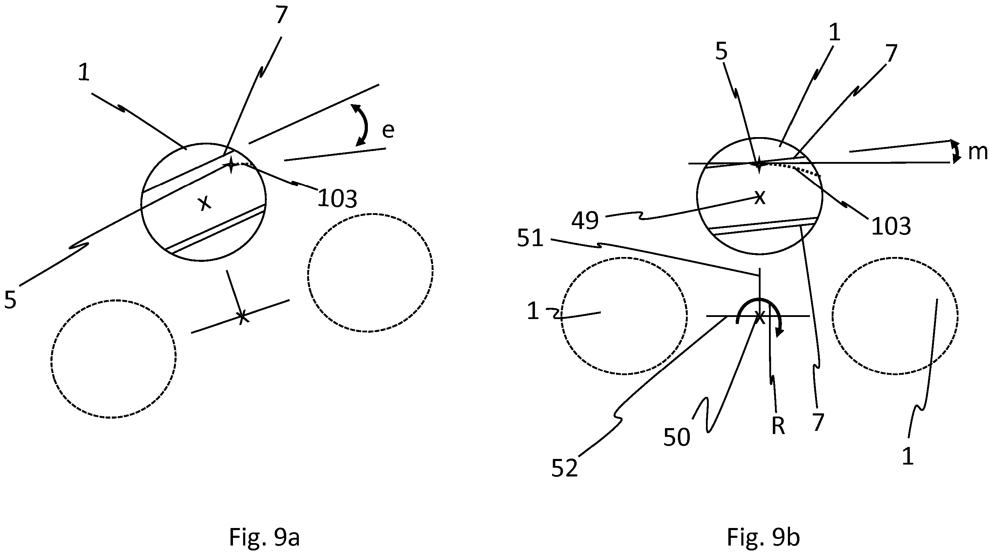

Die Figuren 9a bis 10a zeigen schematisch die Erzeugung einer linienförmigen Gestalt 103 mittels Laser bzw. Lasereinrichtung in einem Spendersubstrat 1. Die linienförmige Gestalt 103 wird hierbei bogenförmig bzw. gebogen erzeugt. Die Lasereinrichtung bzw. der Ort der Modifikationserzeugung verändert sich dabei bevorzugt nicht. D.h. der Ort der Modifikationserzeugung und das Drehzentrum 50 der Rotationseinrichtung 45 bleiben bevorzugt in derselben Ausrichtung zueinander. Es erfolgt somit bevorzugt lediglich eine Bewegung des Spendersubstrats 1 an der Lasereinrichtung 29 vorbei bzw. an einem Auslass für Laserstrahlung 32 vorbei. Das Spendersubstrat 1 wird bevorzugt derart auf der Rotationseinrichtung angeordnet, dass die linienausbildenden Enden 7 der Kristallgitterebenen 6 gegenüber einer sich orthogonal zur Verbindungsstrecke 51 zwischen dem Rotationszentrum 50 der Rotationseinrichtung 45 und dem Zentrum 49 des Spendersubstrats 1 erstreckenden Richtung 52 geneigt, insbesondere in einem Winkel zwischen 3° und 87° und bevorzugt in einem Winkel zwischen 10° und 60° oder 14° und 45°, ausgerichtet sind.

Es kann aus der Gesamtbetrachtung der Figuren 9a-10a erkannt werden, dass mit fortschreitender Rotation der Rotationseinrichtung 45 das Spendersubstrat 1 an der Lasereinrichtung vorbeigeführt wird und die linienförmige Gestalt 103 erzeugt bzw. verlängert wird. Zu Beginn (Fig. 9a) der linienförmigen Gestalt wird diese in einem Winkel e zur Schnittlinie 10 oder zu einer durch das Ende einer Kristallgitterebene ausgebildeten Linie erzeugt. In der Mitte (fig. 9b) der linienförmigen Gestalt wird diese in einem Winkel m zur Schnittlinie 10 oder zu einer durch das Ende einer Kristallgitterebene ausgebildeten Linie erzeugt. Am Ende (Fig. 10a) der linienförmigen Gestalt wird diese in einem Winkel s zur Schnittlinie 10 oder zu einer durch das Ende einer Kristallgitterebene ausgebildeten Linie erzeugt. Der Winkel e ist dabei bevorzugt größer als der Winkel m und der Winkel m ist bevorzugt größer als der Winkel s. Es ist hierbei jedoch ebenfalls denkbar, dass der Winkel s betragsmäßig größer ist als der Winkel m.

Die Winkel werden bevorzugt derart bestimmt, dass die Zentren zweier benachbarter Modifikationen miteinander gedanklich verbunden werden und der Winkel der daraus resultierenden Strecke gegenüber der Schnittlinie 10 oder gegenüber einer durch das Ende 7 einer Kristallgitterebene 6 ausgebildeten Linie bestimmt wird.

Gemäß den Figuren Fig. 9a-10a wird der ideale Schreibwinkel bei einer Anordnung rotierender Substrate als mittlerer Winkel zwischen dem Winkel der Tangenten am Waferrand und der Tangente in der Wafermitte gewählt, d.h. für SiC 30° mittlerer Winkel kann z.B. - abhängig vom Radius des Rotationstisches und des Substratradius' - ein Winkelintervall zwischen 25° und 35° bedeuten, womit z.B. ein bevorzugter Schreibwinkel von 30° für hexagonale Systeme im Mittel gewahrt bleibt.

Fig. 10b zeigt rein beispielhaft eine Draufsicht auf eine Rotationseinrichtung 45. Auf dieser Rotationseinrichtung 45 können eine Vielzahl, insbesondere mehr als 2 oder mehr als 3 oder mehr als 5 oder mehr als 10 bevorzugt bis zu 15 oder bis zu 20 oder bis zu 30 Spendersubstrate, insbesondere Boules oder Ingots oder Wafer, zeitgleich angeordnet sein.

Fig. 10c zeigt eine schematische Seitenansicht einer Anlage zur Erzeugung von Modifikationen 9 im Inneren eines Spendersubstrats 1 bzw. Festkörpers. Bevorzugt ist ein Element 29 einer Lasereinrichtung, insbesondere ein Laserkopf, oder ein mit einem Laser verbundener Strahlenleiter an einer Verfahr- bzw. Umpositioniereinrichtung 30, die bevorzugt raumfest angeordnet ist, angeordnet. Die Verfahr- bzw. Umpositioniereinrichtung 30 ermöglich bevorzugt ein Bewegen des Elements 29 der Lasereinrichtung bzw. ein Bewegen der Lasereinrichtung in bevorzugt linearer Richtung, insbesondere in radialer Richtung der Rotationseinrichtung 45. Somit wird das Element 29 der Lasereinrichtung bzw. die Lasereinrichtung nach dem Erzeugen einer oder mehrerer definierter Schreiblinien 103 auf bevorzugt mehreren oder allen Spendersubstraten 1 umpositioniert. Durch die Umpositionierung werden die emittierten Laserstrahlen an einem anderen Ort 5 zur Modifikationserzeugung in das jeweilige Spendersubstrat 1 eingeleitet.

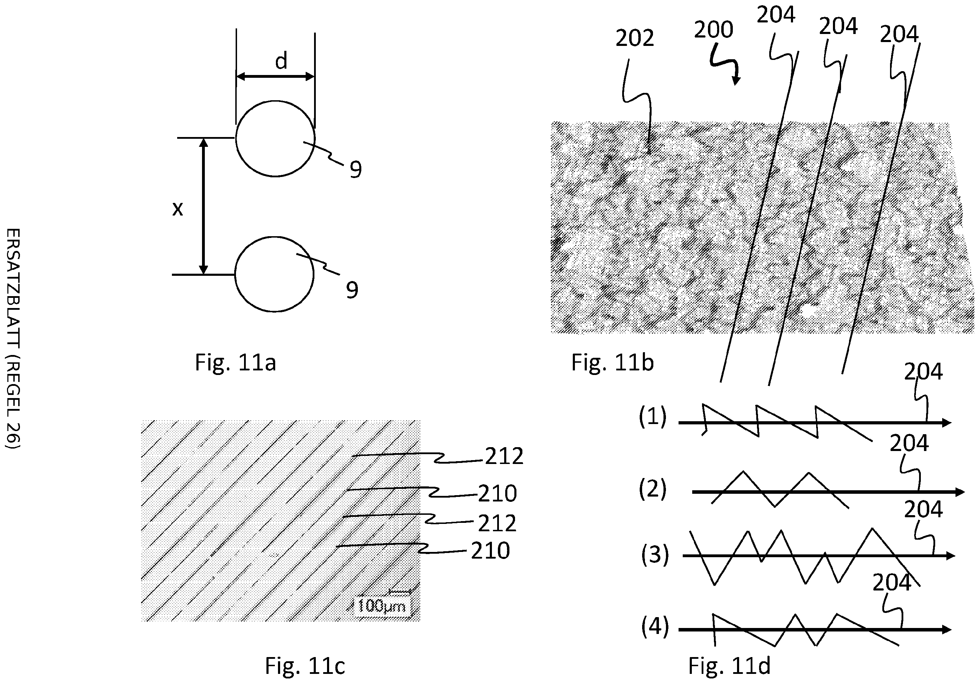

Fig. 11a zeigt die theoretische Basis für die Bedingung (d-x)/d<y, wobei y bevorzugt -0,31 ist oder kleiner als 0,31 oder kleiner als 0,35 oder kleiner als 0,4 ist. Hierbei gilt bevorzugt ferner d = 1.22 * Lambda / NA - beugungsbegrenzte Fokusgröße. x ist bevorzugt der Abstand der Punkte bzw. der Abstand der Zentren zweier nacheinander auf einer linienförmigen Gestalt erzeugten Fokuspunkte. Bevorzugt gilt ferner x> d. Bevorzugt wird eine numerische Apertur verwendet, die größer ist als 0,5 oder die größer ist als 0,6 oder die größer ist als 0,65 oder die größer ist als 0,7 oder die größer ist als 0,75 oder die größer ist als 0,8 oder die größer ist als 0,85.

Fig. 11b zeigt eine durch einen Abtrennschritt freigelegte Oberfläche 200 einer von einem Festkörper abgetrennten Festkörperschicht. Die Oberfläche 200 weist dabei eine Topografie auf, wobei die Topografie längliche zick-zack-förmige Erhebungen aufweist. Die sich länglichen zick-zack förmigen Erhebungen erstrecken sich mehrheitlich und jeweils in ihrer Gesamtheit in einer Richtung 204 oder mehreren Richtungen 204, die von einer Richtung, die parallel zu den Kristallgitterebenen und parallel zur Oberfläche steht verschieden ist, insbesondere dazu in einem Winkel zwischen 2° und 30°, insbesondere zwischen 3° und 15°, insbesondere zwischen 4° und 9°, geneigt ist. Bevorzugt beträgt die mittlere Höhe der zick-zack-förmigen Erhebungen oder die maximale Höhe der zick-zack-förmigen Erhebungen, insbesondere gegenüber der tiefsten Stelle der Oberfläche, weniger als 100 µm, insbesondere weniger als 75µm oder weniger als 50µm oder weniger als 30µm.

Da die Laserenergieschwelle zur Erzeugung eines gleichen Rissbilds oder Schwärzung, d.h. Phasenumwandlung/Lasermodifikation, bei einem Winkel der geschriebenen Linie zum Hauptflat, der nicht null ist, abhängig von der Überfahrtrichtung ist, kann es vorteilhaft sein, die Laserenergie für die jeweilige Bearbeitungsrichtung anzupassen. Dies ist in Fig. 11c gezeigt, wo eine Mäanderfahrt zur Bearbeitung durchgeführt wurde und jede zweite Linie 210 (Bearbeitungsrichtung 1) eine andere Modifikationsstärke aufweist als die jeweils benachbarten Linien 212 (Bearbeitungsrichtung 2). Dementsprechend würden die schwächer ausgebildeten Linien zu einer entsprechend höheren Laserenergie angepasst um das Schadbild möglichst gleichmäßig auszubilden und damit in jeder Linienfahrt eine gleich große Rissbildungswahrscheinlichkeit zu erhalten.

Fig. 11d zeigt vier verschiedene zick-zack förmige Linien (1)-(4). Diese Linien geben schematisch Beispiele vor, welche die Erhebungen 202 oder Vertiefungen aufweisen können. Die Erhebungen 202 oder Vertiefungen können sich dabei abschnittsweise gleichförmig oder in etwa gleichförmig wiederholen. Sich gleichmäßig wiederholende Zickzackmuster werden durch die Muster (1) und (2) gezeigt. Die Erhebungen und Vertiefungen weisen dabei bevorzugt stets einen ersten Anteil auf, der sich in eine erste Richtung erstreckt und einen zweiten Anteil der sich in eine zweite Richtung erstreckt. Bevorzugt wiederholen sich diese Anteile entlang einer Richtung 204, insbesondere entlang der Schreibrichtung bzw. entlang der Richtung, in der die Modifikationen einer linienförmigen Gestalt erzeugt wurden. Es ist hierbei jedoch auch möglich, dass der erste Anteil "je Zacken" oder bei "einzelnen Zacken" gegenüber einer mittleren Länge länger erstreckt oder kürzer erstreckt. Es ist hierbei jedoch zusätzlich oder alternativ auch möglich, dass der zweite Anteil "je Zacken" oder bei "einzelnen Zacken" gegenüber einer mittleren Länge länger erstreckt oder kürzer erstreckt. Bevorzugt kann sich die erste Richtung je Zacken in einem Winkelbereich zwischen 0° und 45°, insbesondere in einem Winkelbereich zwischen 0° und 20° oder zwischen 0° und 5°, verändern. Bevorzugt kann sich zusätzlich oder alternativ die zweite Richtung je Zacken in einem Winkelbereich zwischen 0° und 45°, insbesondere in einem Winkelbereich zwischen 0° und 20° oder zwischen 0° und 5°, verändern. Die Beispiele (3) und (4) zeigen Rissverläufe mit variablen Längenanteilen und Winkeln.

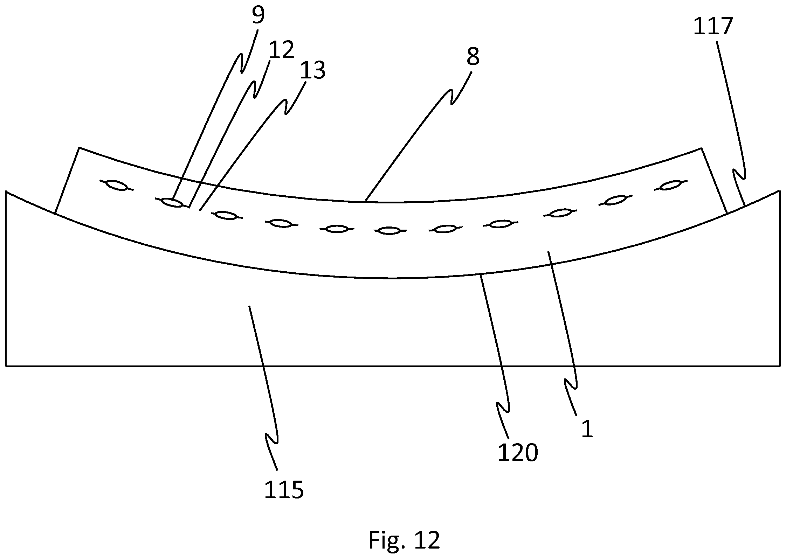

Fig. 12 zeigt eine weitere bevorzugte Ausführungsform. Gemäß dieser Ausführungsform weist das Verfahren zum Erzeugen von Modifikationen 9 im Inneren eines Festkörpers 1 bevorzugt mindestens die Merkmale auf, dass Laserstrahlung 14 eines Lasers 29 über eine erste Oberfläche 8 des Festkörpers 1 in das Innere des Festkörpers 1 eingebracht wird, wobei der Festkörper 1 eine Kristallstruktur ausbildet und wobei durch die Laserstrahlung 14 Modifikationen 9 an vorbestimmten Stellen auf einer Erzeugungsebene 4 im Inneren des Festkörpers 1 erzeugt werden. Die Modifikationen 9 werden dabei bevorzugt näher zur ersten Oberfläche 8 beabstandet erzeugt als zu einer zweiten Oberfläche, wobei die zweite Oberfläche bevorzugt parallel zur ersten Oberfläche 8 ausgebildet ist. Weiterhin weist das Verfahren bevorzugt das Merkmal auf, dass durch die Modifikationen 9 mehrere linienförmige Gestalten 103, insbesondere Schreiblinien, erzeugt werden, wobei der Festkörper 1 im Bereich der jeweiligen Modifikation 9 unterkritisch einreißt.

Ferner kann das Verfahren bevorzugt ebenfalls das Merkmal aufweisen, dass der Festkörper 1 auf eine gebogenen Oberfläche 117 einer Trägereinheit 115 angeordnet wird. Der Festkörper 1 wird durch die Anordnung an der Trägereinheit 115 in einen gebogenen Zustand überführt. Die Oberfläche 117 ist dabei bevorzugt rinnenförmig gebogen. Bevorzugt wird der Festkörper mehrheitlich und besonders bevorzugt vollständig gebogen. Die Biegung der Oberfläche 117 entspricht dabei bevorzugt der eines Ausschnitts einer Kreisbahn. Die Kreisbahn weist dabei bevorzugt einen Radius auf, der bevorzugt in einem Bereich zwischen: (Wurzel aus erster Oberfläche 8 des Festkörpers 1) * 0,25 und (Wurzel aus erster Oberfläche 8 des Festkörpers 1) * 100, insbesondere zwischen (Wurzel aus erster Oberfläche 8 des Festkörpers 1) * 0,5 und (Wurzel aus erster Oberfläche 8 des Festkörpers 1) * 75, insbesondere zwischen (Wurzel aus erster Oberfläche 8 des Festkörpers 1) * 1 und (Wurzel aus erster Oberfläche 8 des Festkörpers 1) * 50, insbesondere zwischen (Wurzel aus erster Oberfläche 8 des Festkörpers 1) * 2 und (Wurzel aus erster Oberfläche 8 des Festkörpers 1) * 25.

Der Festkörper 1 kann z.B. mittels Vakuum an der Trägereinheit 112 angekoppelt werden zusätzlich oder alternativ kann der Festkörper 1 an die Trägereinheit 112 angeklebt sein.

Durch die Biegung entstehen im Festkörper Spannungen 13, welche die Ausbreitung der unterkritischen Risse begrenzen.

Alternativ ist jedoch ebenfalls denkbar, dass der Festkörper 1 an eine Oberfläche einer nach außen gewölbten Trägereinheit angekoppelt wird. Die Biegung der Oberfläche entspricht dabei bevorzugt der eines Ausschnitts einer Kreisbahn. Die Kreisbahn weist dabei bevorzugt einen Radius auf, der bevorzugt in einem Bereich zwischen: (Wurzel aus erster Oberfläche 8 des Festkörpers 1) * 0,25 und (Wurzel aus erster Oberfläche 8 des Festkörpers 1) * 100, insbesondere zwischen (Wurzel aus erster Oberfläche 8 des Festkörpers 1) * 0,5 und (Wurzel aus erster Oberfläche 8 des Festkörpers 1) * 75, insbesondere zwischen (Wurzel aus erster Oberfläche 8 des Festkörpers 1) * 1 und (Wurzel aus erster Oberfläche 8 des Festkörpers 1) * 50, insbesondere zwischen (Wurzel aus erster Oberfläche 8 des Festkörpers 1) * 2 und (Wurzel aus erster Oberfläche 8 des Festkörpers 1) * 25.

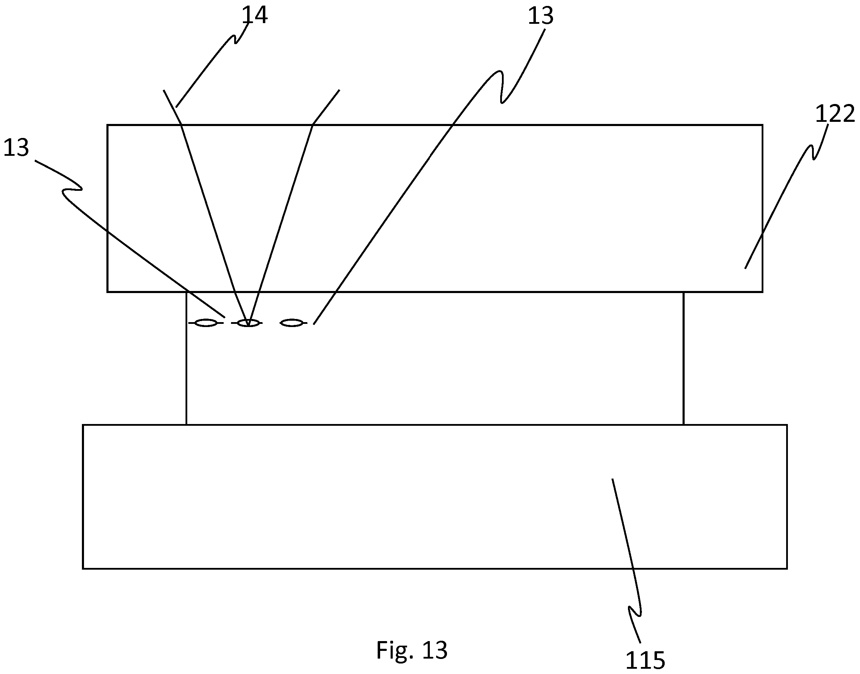

Fig. 13 zeigt eine weitere Ausführungsform. Gemäß dieser Ausführungsform durchdringt die Laserstrahlung zum Erzeugen der Modifikationen vor dem Eintritt in den Festkörper 1 einen für die Laserstrahlung zumindest teilweise transparenten Anpresskörper 122. Der Anpresskörper 122 liegt dabei bevorzugt an der ersten Oberfläche 8 an. Bevorzugt ist der Festkörper 1 dabei an einer Trägereinheit 115 angekoppelt, insbesondere angeklebt und/oder mittels Vakuum fixiert und/oder angepresst.

Bevorzugt weist der Anpresskörper einen Brechungsindex auf, der dem Brechungsindex des Festkörpers entspricht.

Durch den Anpresskörper werden während er Modifikationserzeugung zusätzliche Spannungen im Festkörper erzeugt, wobei diese zusätzlichen Spannungen der Ausbreitung der unterkritischen Risse entgegenwirken.

Weiterhin ist es möglich, dass die Ausführungsformen der Figuren 12 und 13 miteinander kombiniert werden. In diesem Falle weist der Anpresskörper ebenfalls eine gebogene Anpressoberfläche aus, wobei die Anpressoberfläche korrespondierend zu der gebogenen Festkörperoberfläche ausgebildet ist, mit welcher die Anpressoberfläche in Kontakt gebracht wird.

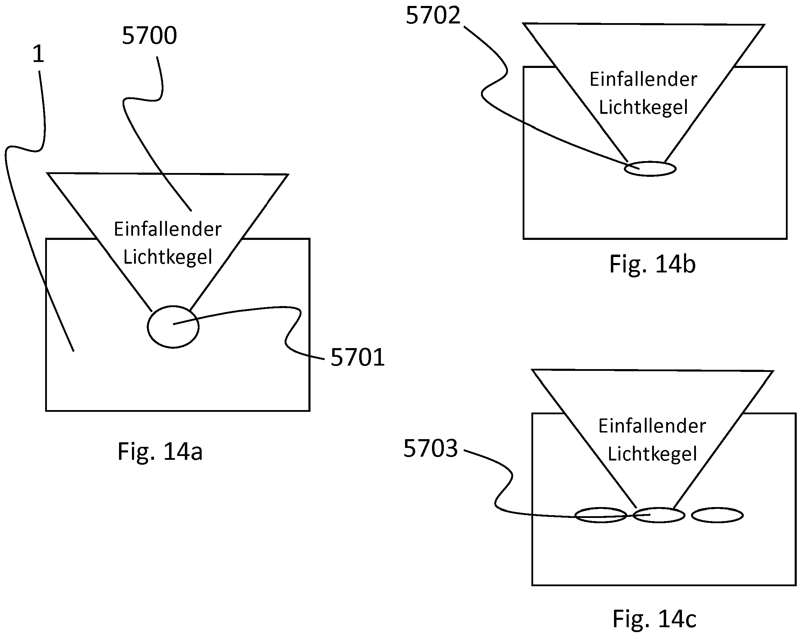

Fig. 14a zeigt einen einfallenden Lichtkegel 5700, durch den im Festkörper 1 ein Fokus 5700 erzeugt wird. Dargestellt ist dabei ein Fokusabbild eines Objektivs durchstrahlt von einem Laser mit gaussschen Strahlprofil.

Fig. 14b stellt schematisch ein Fokusabbild 5702 eines Objektivs durchstrahlt von einem Laser mit NICHT-gaussschen Strahlprofil dar, z.B. nachdem der Strahl durch einen SLM verändert wurde. Ein Spatial light modulator (SLM) ist dabei ein räumlicher Modulator für Licht und somit ein Gerät durch das Licht eine räumliche Modulation aufprägbar ist. Gegenüber dem gausschen Strahlprofil ist die Z-Ausdehnung des Fokuspunktes deutlich reduziert bzw. reduzierbar.

Fig. 14c stellt schematisch ein Fokusabbild 5703 eines Objektivs durchstrahlt von einem Laser mit NICHT-gaussschen Strahlprofil dar, z.B. nachdem der Strahl durch einen diffraktives optisches Element (DOE) verändert wurde. Der Strahl ist dabei bevorzugt zum Ausbilden mehrerer Fokusse durch das DOE aufgeteilt. Ein DOE dient dabei bevorzugt dazu die Beugung eines Laserstrahls um die räumliche Abbildung des Fokuspunktes zu verändern.

Diffraktive optische Elemente (DOEs) wirken durch Beugung auf Laserstrahlung ein. Hierbei werden Strukturen verwendet, die auf der Größenskala der Laserwellenlänge liegen. Mittels numerischer Simulation der Lichtbeugung an beugenden Strukturen wird ein Element berechnet, was dann in größeren Stückzahlen hergestellt werden kann. Generell wird die räumliche Verteilung des Lichts im Laserstrahlprofil geändert, entweder direkt nach dem Element oder im Brennpunkt nach einem fokussierenden Element. Dies bedeutet, dass z.B. ein Strahl in mehrere Strahlen aufgespalten werden kann, dass ein - üblicherweise auftretendes - Gauß-Strahlintensitätsprofil in eine andere Form überführt wird, oder dass sich die Intensitätsverteilung der Laserstrahlung im Fokus in einer durch herkömmliche Linsen nicht erreichbaren Weise ändert, z.B. durch das bewusste Einbringen oder Unterdrücken von Nebenmaxima, die für die erwünschte Laserwechselwirkung erforderlich sind.

Im Gegensatz dazu ist ein räumlicher Modulator für Licht (englisch: Spatial Light Modulator (SLM)) ein Gerät, um Licht eine räumliche Modulation aufzuprägen.

Gewöhnlicherweise moduliert ein SLM die Intensität eines Lichtstrahls, es ist jedoch auch möglich, die Phase oder auch die Phase und die Intensität gleichzeitig zu modulieren.

Diese räumliche Modulation wird beim DOE durch die Strukturen im Element vorgenommen, beim SLM hingegen durch die einzelnen Pixel am SLM. Besonders nach Abbildung oder Fokussierung eines intensitäts- und phasenmodulierten Strahls sind damit programmierbare Intensitätsverteilungen im Fokus zu erreichen. Während ein DOE also statisch und reproduzierbar auf den Laserstrahl wirkt, kann z.B. mit Hilfe eines SLM die Zahl der Strahlen oder auch das verwendete Laserstrahlprofil in einer Laserbearbeitungsvorrichtung dynamisch umgeschaltet werden. Auch ist eine dynamische Anpassung im Prozessverlauf möglich, z.B. nach Feedback einer gleichzeitigen Überwachung des Prozessfortschritts.

Das hiermit vorgeschlagene Verfahren weist den Schritt des Veränderns einer Strahleigenschaften der Laserstrahlen vor dem Eindringen in den Festkörper auf, wobei die Strahleigenschaft die Intensitätsverteilung im Fokus ist, wobei die Veränderung oder Anpassung der Strahleigenschaft von mindestens oder genau einem Spatial Light Modulator und/oder von mindestens oder genau einem DOE bewirkt wird, wobei der Spatial Light Modulator und/oder das DOE im Strahlengang der Laserstrahlung zwischen dem Festkörper und der Strahlungsquelle angeordnet ist.

Zur Erläuterung der Funktionsweise von DOEs und Spatial Light Modulatoren wird auf die nachfolgend genannte Druckschrift verwiesen: Flexible beam shaping system for the next generation of process development in laser micromachining, LANE 2016, 9th International Conference on Photonic Technologies LANE 2016, Tobias Klerks, Stephan Eifel.

Laserstrahlintensitätsprofile die von der normalerweise üblichen Gaussform abweichen werden als nicht-gaussche Strahlenprofile bezeichnet und können eingesetzt werden, um ein anderes Bearbeitungsergebnis zu erzielen. So ist z.B. ein Linienfokus denkbar, der in einer Dimension senkrecht zur Strahlfortpflanzungsrichtung eine deutlich andere Ausdehnung aufweist als in einer zweiten Dimension. Dies ermöglicht ein Überstreichen breiterer Bereiche des Werkstücks mit dem Laserstrahl im Bearbeitungsschritt. Als "top-hat"-Profil wird vorliegend ein Profil bezeichnet, das eine konstante Intensität im Zentrum des Strahls aufweist, was den Vorteil bietet, dass in der Bearbeitung im Fokus keine Bereiche unterschiedlicher Intensität vorliegen oder zumindest nur Bereiche gleicher Intensität über der Laserbearbeitungsschwelle liegen. Dies kann zum Beispiel zur Minimierung der Schleifverluste nach dem Trennen dienen.

Der vorliegende Gegenstand bezieht sich somit bevorzugt auf ein Verfahren zum Erzeugen von Modifikationen 9 im Inneren eines Festkörpers 1. Das Verfahren weist dabei bevorzugt den Schritt des Einbringens von Laserstrahlung 14 eines Lasers 29 über eine erste Oberfläche 8 des Festkörpers 1 in das Innere des Festkörpers 1 auf. Die Oberfläche 8, über welche die Laserstrahlung 14 in den Festkörper 1 eindringt, ist bevorzugt Bestandteil der abzutrennenden Festkörperschicht. Bevorzugt ist die abzutrennende Festkörperschicht dünner als der verbleibende Restfestkörperanteil.

Bevorzugt bildet der Festkörper 1 eine Kristallstruktur aus und durch die Laserstrahlung 14 werden Modifikationen 9 an vorbestimmten Stellen auf einer Erzeugungsebene 4 im Inneren des Festkörpers 1 erzeugt. Die Erzeugungsebene ist dabei bevorzugt parallel zur ersten Oberfläche 8. Die Modifikationen 9 sind bevorzugt näher zur ersten Oberfläche 8 beabstandet als zu einer zweiten Oberfläche, wobei die zweite Oberfläche bevorzugt parallel zur ersten Oberfläche 8 ausgebildet ist. Durch die Modifikationen 9 werden mehrere linienförmige Gestalten 103, insbesondere gepunktete oder durchgängige Schreiblinien, erzeugt, wobei der Festkörper 1 im Bereich der jeweiligen Modifikation 9 unterkritisch einreißt, wobei die unterkritischen Risse orthogonal zur Längserstreckungsrichtung der jeweiligen linienförmigen Gestalt eine Risslänge bzw. mittlere Risslänge von weniger als 150 µm, insbesondere von weniger als 120 µm oder weniger als 110 µm oder weniger als 90 µm oder weniger als 75 µm oder weniger als 60 µm, aufweist.

Die Modifikationen 9, die zur selben linienförmigen Gestalt 103 gehören und nacheinander erzeugt werden, werden bevorzugt in einem Abstand zueinander erzeugt, der durch die Funktion (d-x)/d<-0,31, insbesondere <-0,4 , definiert wird.

Zusätzlich oder alternativ kann die Laserstrahlung definiert polarisiert sein. Die Polarisationsrichtung der Laserstrahlung 14 ist dabei bevorzugt in einem definierten Winkel oder in einem definierten Winkelbereich gegenüber der Kristallachse des Festkörpers 1 orientiert oder die Längserstreckungsrichtung R der mittels der Laserstrahlen 14 im Inneren des Festkörpers 1 erzeugten Modifikationen 9 in einem definierten Winkel oder in einem definierten Winkelbereich gegenüber einer sich an der Schnittstelle zwischen der Erzeugungsebene 4 und der Kristallgitterebene 6 ergebenden Schnittlinie 10 ausgerichtet ist. Weiterhin kann sich der vorliegende Gegenstand auf ein Verfahren zum Herstellen von mindestens einer Festkörperschicht, insbesondere zum Abtrennen von mindestens einer Festkörperschicht von einem Festkörper, beziehen. Dieses Verfahren weist dabei bevorzugt mindestens die Schritte auf: Durchführen eines Verfahrens gemäß einem der Ansprüche 1 bis 13, Einleiten einer äußeren Kraft in den Festkörper 1 zum Erzeugen von Spannungen in dem Festkörper 1 und/oder Erzeugen einer inneren Kraft in dem Festkörper 1, wobei die äußere und/oder innere Kraft so stark ist, dass daraus eine Rissausbreitung entlang der Ablösebereich 8 resultiert.

Weitere Grundlagen für die Patentansprüche sowie weitere Aspekte dieser Offenbarung sind wie folgt:
1. Verfahren zum Erzeugen von Modifikationen (9) im Inneren eines Festkörpers (1), mindestens umfassend
   das Einbringen von Laserstrahlung (14) eines Lasers (29) über eine erste Oberfläche (8) des Festkörpers (1) in das Innere des Festkörpers (1),
      wobei der Festkörper (1) eine Kristallstruktur ausbildet und
      wobei durch die Laserstrahlung (14) Modifikationen (9) an vorbestimmten Stellen auf einer Erzeugungsebene (4) im Inneren des Festkörpers (1) erzeugt werden,
      wobei die zweite Oberfläche parallel zur ersten Oberfläche (8) ausgebildet ist,
      wobei durch die Modifikationen (9) mehrere linienförmige Gestalten (103) erzeugt werden,
      wobei der Festkörper (1) im Bereich der jeweiligen Modifikation (9) unterkritisch einreißt,
         wobei die unterkritischen Risse orthogonal zur Längserstreckungsrichtung der jeweiligen linienförmigen Gestalt eine mittlere Risslänge von weniger als 150 µm aufweist,
   wobei Modifikationen (9), die zur selben linienförmigen Gestalt (103) gehören und nacheinander erzeugt werden in einem Abstand zueinander erzeugt werden, der durch die Funktion (d-x)/d<-0,31 definiert wird, wobei hierbei x>d gilt.
2. Verfahren nach Ziffer 1,
   dadurch gekennzeichnet, dass
   die Laserstrahlung (14) definiert polarisiert ist,
   wobei die Polarisationsrichtung der Laserstrahlung in einem definierten Winkel oder definierten Winkelbereich gegenüber der Kristallachse des Festkörpers orientiert ist
      oder
   wobei die Längserstreckungsrichtung (R) der mittels der Laserstrahlen (14) im Inneren des Festkörpers (1) erzeugten Modifikationen (9) in einem definierten Winkel oder definierten Winkelbereich gegenüber einer sich an der Schnittstelle zwischen der Erzeugungsebene (4) und der Kristallgitterebene (6) ergebenden Schnittlinie (10) ausgerichtet ist.
3. Verfahren zum Erzeugen von Modifikationen (9) im Inneren eines Festkörpers (1),
   mindestens umfassend
   das Einbringen von Laserstrahlung (14) eines Lasers (29) über eine erste Oberfläche (8) des Festkörpers (1) in das Innere des Festkörpers (1),
      wobei der Festkörper (1) eine Kristallstruktur ausbildet und
      wobei durch die Laserstrahlung (14) Modifikationen (9) an vorbestimmten Stellen auf einer Erzeugungsebene (4) im Inneren des Festkörpers (1) erzeugt werden,
      wobei die zweite Oberfläche parallel zur ersten Oberfläche (8) ausgebildet ist,
      wobei durch die Modifikationen (9) mehrere linienförmige Gestalten (103) erzeugt werden,
      wobei der Festkörper (1) im Bereich der jeweiligen Modifikation (9) unterkritisch einreißt,
         wobei die unterkritischen Risse orthogonal zur Längserstreckungsrichtung der jeweiligen linienförmigen Gestalt eine mittlere Risslänge von weniger als 150 µm aufweist,
   wobei die Laserstrahlung definiert polarisiert ist,
      wobei die Polarisationsrichtung der Laserstrahlung (14) in einem definierten Winkel oder in einem definierten Winkelbereich gegenüber der Kristallachse des Festkörpers (1) orientiert ist
         oder
      wobei die Längserstreckungsrichtung (R) der mittels der Laserstrahlen (14) im Inneren des Festkörpers (1) erzeugten Modifikationen (9) in einem definierten Winkel oder in einem definierten Winkelbereich gegenüber einer sich an der Schnittstelle zwischen der Erzeugungsebene (4) und der Kristallgitterebene (6) ergebenden Schnittlinie (10) ausgerichtet ist.
4. Verfahren nach Ziffer 1 oder 3,
   dadurch gekennzeichnet, dass
   Modifikationen (9), die zur selben linienförmigen Gestalt (103) gehören und nacheinander erzeugt werden in einem Abstand zueinander erzeugt werden, der durch die Funktion (d-x)/d<0 definiert wird, wobei hierbei x>d gilt.
5. Verfahren nach Ziffer 4,
   dadurch gekennzeichnet, dass
   die nacheinander erzeugten Modifikationen einer linienförmigen Gestalt durch unmodifiziertes Festkörpermaterial voneinander getrennt sind
6. Verfahren nach einer der vorangegangenen Ziffern,
   dadurch gekennzeichnet, dass
   der Abstand zwischen jeweils zwei unmittelbar nebeneinanderliegenden linienförmigen Gestalten (103) weniger als 50µm beträgt.
7. Verfahren nach einer der vorangegangenen Ziffern,
   dadurch gekennzeichnet, dass
   die in dem Festkörper (1) erzeugten Modifikationen (9) zu einem ersten Teil während einer ersten Relativbewegung des Festkörpers (1) gegenüber einer Optik des Lasers (29) erzeugt werden und zu einem zweiten Teil während einer zweiten Relativbewegung des Festkörpers (1) gegenüber der Optik des Lasers (29) erzeugt werden.
8. Verfahren nach Ziffer 7,
   dadurch gekennzeichnet, dass
   mindestens die Einstellung eines Laserparameters während der ersten Relativbewegung von der Einstellung während der zweiten Relativbewegung abweicht, wobei die erste Relativbewegung einer linearen Bewegung in einer ersten Richtung entspricht und die zweite Relativbewegung einer linearen Bewegung in einer zweiten Richtung entspricht, wobei die erste Richtung und die zweite Richtung parallel zueinander orientiert sind.
9. Verfahren nach einer der vorangegangenen Ziffern,
   dadurch gekennzeichnet, dass
   die Laserstrahlung (14) linear polarisiert ist
      oder
   elliptisch polarisiert ist
      oder
   zirkular polarisiert ist.
10. Verfahren nach einer der vorangegangenen Ziffern,
   dadurch gekennzeichnet, dass
   im Weg der Laserstrahlung (14) vor dem Eindringen der Laserstrahlung (14) in den Festkörper (1) ein diffraktives optisches Element (DOE) angeordnet ist, wobei die Laserstrahlung (14) durch das DOE auf mehrere Lichtpfade zum Erzeugen mehrerer Fokusse aufgeteilt wird.
11. Verfahren nach einer der vorangegangenen Ziffern,
   dadurch gekennzeichnet, dass
   der Festkörper (1) Kristallgitterebenen (6) aufweist, die gegenüber der ersten Oberfläche (8) geneigt sind, wobei die erste Oberfläche (8) des Festkörpers (1) in Längsrichtung des Festkörpers (1) einerseits begrenzt, wobei sich eine Kritallgitterebenennormale (60) gegenüber einer Hauptoberflächennormalen (80) in eine erste Richtung neigt,
   wobei die Veränderungen der Materialeigenschaft auf einer Erzeugungsebene (4) erzeugt werden,
   wobei die Kristallgitterebenen (6) des Festkörpers (1) gegenüber der Erzeugungsebene (4) geneigt ausgerichtet sind,
   wobei die linienförmigen Gestalten (103) gegenüber einer sich an der Schnittstelle zwischen der Erzeugungsebene (4) und der Kristallgitterebene (6) ergebenden Schnittlinie geneigt ausgerichtet sind.
12. Verfahren einer der vorangegangenen Ziffern,
   dadurch gekennzeichnet, dass
   soviel Material des Festkörpers (1) unter Ausbildung einer linienförmigen Gestalt (103) verändert wird, dass sich infolge einer Festkörperschichtenabtrennung aus den freigelegten Enden der einzelnen Kristallgitterebenen (6) und den Materialveränderungen Moirémuster ergeben, wobei hierzu eine Vielzahl sich linienförmig Materialveränderungsbereiche erzeugt werden.
13. Verfahren nach einerm der vorangegangenen Ziffern,
   ferner umfassend die Schritte:
   Bewegen des Festkörpers (1) relativ zum Laser,
   wobei der Laser zur definierten Fokussierung der Laserstrahlung und/oder zur Anpassung der Laserenergie kontinuierlich in Abhängigkeit von mindestens einem Parameter eingestellt wird, wobei
   ein Parameter der Grad der Dotierung des Festkörpers (1) an einem vorbestimmten Ort oder in einem vorbestimmten Bereich ist.
14. Verfahren zum Herstellen von mindestens einer Festkörperschicht,
   mindestens umfassend die Schritte:
   Durchführen eines Verfahrens gemäß einer der Ziffern 1 bis 13,
   Einleiten einer äußeren Kraft in den Festkörper (1) zum Erzeugen von Spannungen in dem Festkörper (1) und/oder Erzeugen einer inneren Kraft in dem Festkörper (1), wobei die äußere und/oder innere Kraft so stark ist, dass daraus eine Rissausbreitung entlang der Ablösebereich (8) resultiert.
15. Festkörperschicht,
   dadurch gekennzeichnet, dass
   die Festkörperschicht (2) SiC aufweist oder draus besteht,
   und eine Oberfläche (200) ausbildet, wobei die Oberfläche (200) eine Topografie ausbildet,
   wobei die Topografie längliche zick-zack-förmige Erhebungen aufweist,
   wobei sich die länglichen zick-zack förmigen Erhebungen mehrheitlich und jeweils in ihrer Gesamtheit in einer Richtung (204) oder mehreren Richtungen (204) erstrecken, die von einer Richtung, die parallel zu den Kristallgitterebenen und parallel zur Oberfläche steht verschieden ist geneigt ist,
   wobei die mittlere Höhe der zick-zack-förmigen Erhebungen oder die maximale Höhe der zick-zack-förmigen Erhebungen, gegenüber der tiefsten Stelle der Oberfläche weniger als 100 µm beträgt.
16. Festkörperschicht,
   dadurch gekennzeichnet, dass
   die Festkörperschicht (2) SiC aufweist oder draus besteht,
   und eine Oberfläche (200) ausbildet,
   wobei als Bestandteil der Oberfläche (200) und entlang zueinander paralleler und entlang der Oberfläche erstreckender und voneinander beabstandeter Erstreckungsrichtungen phasenumgewandelte Materialbestandteile vorliegen,
   wobei die zueinander parallelen und voneinander beabstandeten Erstreckungsrichtungen gegenüber einer Richtung, die parallel zu den Kristallgitterebenen und parallel zur
   Oberfläche orientiert ist, in einem Winkel zwischen 2° und 30°, insbesondere zwischen 3° und 15°, geneigt sind.

### Bezugszeichenliste

| | | | |
|---|---|---|---|
| 1 | Festkörper / Spendersubstrat | 60 | Kristallgitterebenennormale |
| 2 | Festkörperschicht | 80 | Hauptoberflächennormale |
| 4 | Erzeugungsebene | 90 | Normalebene |
| 5 | Ort zur Modifikationserzeugung | 92 | Orthogonalebene zur Normalenebene |
| 6 | Kristallgitterebene | 94 | Erstreckungsrichtung der Enden der |
| 6a/b/c | Kristallgitterebenen | | Kristallgitterebenen |
| 7 | Ende der Kristallgitterebene | 103 | Laserlinie / Schreiblinie |
| 8 | Hauptoberfläche /erste Oberfläche | 115 | Chuck / Trägereinheit |
| 9 | Modifikation | 117 | gebogene Oberfläche |
| 9a/b | Modifikationen | 120 | Verbindungsstelle |
| 10 | Schnittlinie | 122 | Für die Laserstrahlung zumindest teilweise transparenter Körper |
| 12 | unterkritischer Riss | 200 | Durch Abtrennen freigelegte Oberfläche der Festkörperschicht |
| 11 | Flat | | |
| 13 | mechanische Spannungen | 202 | zick-zack-förmige Erhebungen |
| 14 | Laserstrahlung | 204 | Richtung der Erstreckung der zick-zack-förmige Erhebung/en |
| 29 | Laser | | |
| 30 | Umpositioniereinrichtung | 210 | erste Richtung |
| 32 | Laserstrahlung | 212 | zweite Richtung (entgegengesetzt zur ersten Richtung 210) |
| 45 | Rotationseinrichtung | 5700 | Lichtkegel |
| 49 | Zentrum | 5702 | Fokusabbild |
| 50 | Drehzentrum | 5703 | Fokusabbild |
| 51 | Verbindungsstrecke | R | Längserstreckungsrichtung der |
| 52 | Richtung | | Modifikation |

## Patentansprüche

1. Verfahren zum Erzeugen von Modifikationen (9) im Inneren eines Festkörpers (1), mindestens umfassend
das Einbringen von Laserstrahlung (14) eines Lasers (29) über eine erste Oberfläche (8) des Festkörpers (1) in das Innere des Festkörpers (1),
wobei der Festkörper (1) eine Kristallstruktur ausbildet, wobei durch die Laserstrahlung (14) Modifikationen (9) an vorbestimmten Stellen auf einer Erzeugungsebene (4) im Inneren des Festkörpers (1) erzeugt werden,
wobei durch die Modifikationen (9) mehrere linienförmige Gestalten (103) erzeugt werden,
wobei der Festkörper (1) im Bereich der jeweiligen Modifikation (9) unterkritisch einreißt,
wobei die unterkritischen Risse orthogonal zur Längserstreckungsrichtung der jeweiligen linienförmigen Gestalt eine mittlere Risslänge von weniger als 150 µm aufweisen,
wobei die Laserstrahlung definiert polarisiert ist,
wobei eine Polarisationsrichtung der Laserstrahlung in einem Winkelbereich von -20° bis 20° oder 80° bis 100° gegenüber einer Kristallachse des Festkörpers (1) orientiert ist oder wobei eine Längserstreckungsrichtung (R) der mittels der Laserstrahlen (14) im Inneren des Festkörpers (1) erzeugten Modifikationen (9) in einem definierten Winkel oder in einem definierten Winkelbereich gegenüber einer sich an der Schnittstelle zwischen der Erzeugungsebene (4) und der Kristallgitterebene (6) ergebenden Schnittlinie (10) ausgerichtet ist und dabei von einer Längserstreckungsrichtung der Schnittlinie (10) abweicht.

2. Verfahren nach Anspruch 1, **dadurch gekennzeichnet,**
**dass** Modifikationen (9), die zur selben linienförmigen Gestalt (103) gehören und nacheinander erzeugt werden, in einem Abstand zueinander erzeugt werden, der durch die Funktion (d-x)/d<0 definiert wird, wobei d einen Durchmesser der Modifikation (9) und x einen Mitte-zu-Mitte Abstand benachbarter Modifikationen angibt.

3. Verfahren nach Anspruch 2, **dadurch gekennzeichnet,**
**dass** die nacheinander erzeugten Modifikationen (9) einer linienförmigen Gestalt (103) durch unmodifiziertes Festkörpermaterial voneinander getrennt sind.

4. Verfahren nach einem der vorangegangenen Ansprüche, **dadurch gekennzeichnet,**
**dass** der Abstand zwischen jeweils zwei unmittelbar nebeneinanderliegenden linienförmigen Gestalten (103) weniger als 50µm beträgt.

5. Verfahren nach einem der vorangegangenen Ansprüche, **dadurch gekennzeichnet,**
**dass** die in dem Festkörper (1) erzeugten Modifikationen (9) zu einem ersten Teil während einer ersten Relativbewegung des Festkörpers (1) gegenüber einer Optik des Lasers (29) erzeugt werden und zu einem zweiten Teil während einer zweiten Relativbewegung des Festkörpers (1) gegenüber der Optik des Lasers (29) erzeugt werden.

6. Verfahren nach Anspruch 5, **dadurch gekennzeichnet,**
**dass** die Einstellung mindestens eines Laserparameters während der ersten Relativbewegung von der Einstellung während der zweiten Relativbewegung abweicht, wobei die erste Relativbewegung einer linearen Bewegung in einer ersten Richtung entspricht und die zweite Relativbewegung einer linearen Bewegung in einer zweiten Richtung entspricht, wobei die erste Richtung und die zweite Richtung parallel zueinander orientiert sind.

7. Verfahren nach einem der vorangegangenen Ansprüche, **dadurch gekennzeichnet,**
**dass** die Laserstrahlung (14) linear polarisiert ist oder elliptisch polarisiert ist oder zirkular polarisiert ist.

8. Verfahren nach einem der vorangegangenen Ansprüche, **dadurch gekennzeichnet**
**dass** im Weg der Laserstrahlung (14) vor dem Eindringen der Laserstrahlung (14) in den Festkörper (1) ein diffraktives optisches Element (DOE) angeordnet ist, wobei die Laserstrahlung (14) durch das DOE auf mehrere Lichtpfade zum Erzeugen mehrerer Fokusse aufgeteilt wird.

9. Verfahren nach einem der vorangegangenen Ansprüche, **dadurch gekennzeichnet,**
**dass** der Festkörper (1) Kristallgitterebenen (6) aufweist, die gegenüber der ersten Oberfläche (8) geneigt sind, wobei die erste Oberfläche (8) des Festkörpers (1) in Längsrichtung des Festkörpers (1) einerseits begrenzt, wobei sich eine Kristallgitterebenennormale (60) gegenüber einer Hauptoberflächennormalen (80) in eine erste Richtung neigt,
wobei die Veränderungen der Materialeigenschaft auf einer Erzeugungsebene (4) erzeugt werden,
wobei die Kristallgitterebenen (6) des Festkörpers (1) gegenüber der Erzeugungsebene (4) geneigt ausgerichtet sind,
wobei die linienförmigen Gestalten (103) gegenüber einer sich an der Schnittstelle zwischen der Erzeugungsebene (4) und der Kristallgitterebene (6) ergebenden Schnittlinie (10) geneigt ausgerichtet sind.

10. Verfahren einem der vorangegangenen Ansprüche, **dadurch gekennzeichnet,**
**dass** so viel Material des Festkörpers (1) unter Ausbildung einer linienförmigen Gestalt (103) verändert wird, dass sich infolge einer Festkörperschichtenabtrennung aus den freigelegten Enden der einzelnen Kristallgitterebenen (6) und den Materialveränderungen Moirémuster ergeben, wobei hierzu eine Vielzahl sich linienförmig Materialveränderungsbereiche erzeugt werden.

11. Verfahren nach einem der vorangegangenen Ansprüche, ferner umfassend die Schritte:
Bewegen des Festkörpers (1) relativ zum Laser,
wobei der Laser zur definierten Fokussierung der Laserstrahlung und/oder zur Anpassung der Laserenergie kontinuierlich in Abhängigkeit von mindestens einem Parameter eingestellt wird,
wobei ein Parameter der Grad der Dotierung des Festkörpers (1) an einem vorbestimmten Ort oder in einem vorbestimmten Bereich ist.

12. Verfahren zum Herstellen von mindestens einer Festkörperschicht, mindestens umfassend die Schritte:
Durchführen eines Verfahrens gemäß einem der Ansprüche 1 bis 11, und
Einleiten einer äußeren Kraft in den Festkörper (1) zum Erzeugen von Spannungen in dem Festkörper (1) und/oder Erzeugen einer inneren Kraft in dem Festkörper (1), wobei die äußere und/oder innere Kraft so stark ist, dass daraus eine Rissausbreitung entlang der Ablösebereich (8) resultiert.

13. Festkörperschicht hergestellt nach dem Verfahren gemäß Anspruch 12, wobei
die Festkörperschicht (2) SiC aufweist oder daraus besteht und eine Oberfläche (200) ausbildet, wobei die Oberfläche (200) eine Topografie ausbildet,
wobei die Topografie längliche zick-zack-förmige Erhebungen aufweist,
wobei sich die länglichen zick-zack förmigen Erhebungen mehrheitlich und jeweils in ihrer Gesamtheit in einer Richtung (204) oder mehreren Richtungen (204) erstrecken, die von einer Richtung, die parallel zu den Kristallgitterebenen und parallel zur Oberfläche steht verschieden ist geneigt ist,
wobei die mittlere Höhe der zick-zack-förmigen Erhebungen oder die maximale Höhe der zick-zack-förmigen Erhebungen, gegenüber der tiefsten Stelle der Oberfläche weniger als 100 µm beträgt.

14. Festkörperschicht hergestellt nach dem Verfahren gemäß Anspruch 12, wobei
die Festkörperschicht (2) SiC aufweist oder daraus besteht, und eine Oberfläche (200) ausbildet,
wobei als Bestandteil der Oberfläche (200) und entlang zueinander paralleler und entlang der Oberfläche erstreckender und voneinander beabstandeter Erstreckungsrichtungen phasenumgewandelte Materialbestandteile vorliegen,
wobei die zueinander parallelen und voneinander beabstandeten Erstreckungsrichtungen gegenüber einer Richtung, die parallel zu den Kristallgitterebenen und parallel zur Oberfläche orientiert ist, in einem Winkel zwischen 2° und 30°, insbesondere zwischen 3° und 15°, geneigt sind.
